# EUROPEAN PATENT SPECIFICATION

(11) **EP 4 404 265 B1**
(45) Date of publication and mention of the grant of the patent: **25.11.2026**
(21) Application number: 23778079.6
(22) Date of filing: 27.03.2023
(51) Int. Cl.: H10D 12/00, H10D 12/01, H10D 62/10, H10D 62/13, H10D 62/17, H10D 64/00, H10D 8/00, H10D 8/01, H10D 84/00, H10D 84/80, H10P 30/20, H10P 30/22

(54) **SEMICONDUCTOR DEVICE, AND RELATED CIRCUIT, CHIP, ELECTRONIC DEVICE AND PREPARATION METHOD**
HALBLEITERBAUELEMENT UND ZUGEHÖRIGE SCHALTUNG, CHIP, ELEKTRONISCHE VORRICHTUNG UND HERSTELLUNGSVERFAHREN
DISPOSITIF À SEMI-CONDUCTEUR ET CIRCUIT ASSOCIÉ, PUCE, DISPOSITIF ÉLECTRONIQUE ET PROCÉDÉ DE PRÉPARATION

(30) Priority: 30.03.2022 CN 202210327363
(43) Date of publication of application: 24.07.2024
(73) Proprietor: Huawei Digital Power Technologies Co., Ltd., Shenzhen, Guangdong 518043 (CN)
(72) Inventor: YANG, Wentao, Shenzhen, Guangdong 518043 (CN); ZHAO, Qian, Shenzhen, Guangdong 518043 (CN); WANG, Lianghao, Shenzhen, Guangdong 518043 (CN); DAI, Loucheng, Shenzhen, Guangdong 518043 (CN)
(74) Representative: Isarpatent
(86) International application number: PCT/CN2023/084016
(87) International publication number: WO 2023/185712

(56) References cited:
- CN-A- 103 489 908
- CN-A- 109 860 284
- CN-A- 113 990 926
- JP-A- 2010 171 057
- US-A1- 2008 048 295
- US-A1- 2008 048 295

## Description

### TECHNICAL FIELD

The present disclosure relates to a power semiconductor device, a related circuit, a chip, and an electronic device.

### BACKGROUND

An insulated gate bipolar transistor (IGBT) is a complex fully controlled voltage-driven power semiconductor device including a bipolar junction transistor (BJT) and an metal-oxide-semiconductor field-effect transistor (MOSFET).

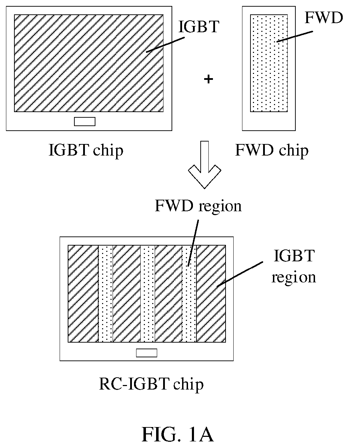

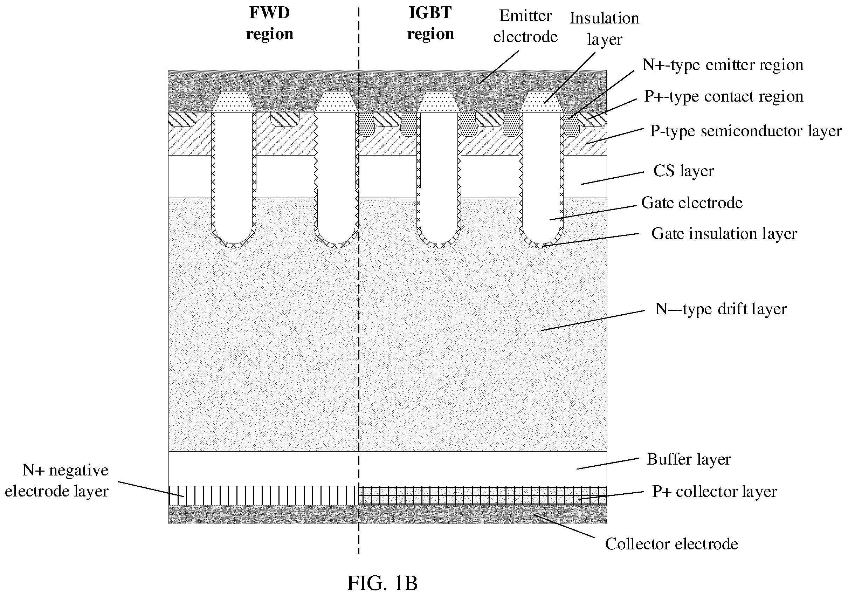

To improve power density of the IGBT, the IGBT and a diode, for example, a freewheeling diode (FWD), may be integrated into one chip, and a formed structure is referred to as a reverse conduction IGBT (RC-IGBT). FIG. 1A is a schematic top view of a chip before and after integration. FIG. 1B is a schematic cross-sectional view of an RC-IGBT chip. The RC-IGBT chips shown in FIG. 1A and FIG. 1B integrate functions of an IGBT and an FWD in a single-chip form, and two chips are converted into one chip. In this way, a total area of the chip can be reduced by about 20%, total costs of the chip can be reduced by about 15%, and power density of the devices can be increased by 20% in a same package size. In addition, in an RC-IGBT working process, an IGBT region and an FWD region may assist each other in heat dissipation, and thermal resistance can be reduced by about 30%, so that thermal performance of a system is improved.

However, the foregoing N-channel IGBT is used as an example, and the RC-IGBT chip shown in FIG. 1B injects a large quantity of holes into a contact region in the FWD region. Consequently, excessive carriers are injected into a positive electrode of the FWD, resulting in a high reverse recovery loss of the FWD. JP 2010171057 A relates to a semiconductor device comprising a RC-IGBT that integrates an IGBT region and a FWD region on a common n⁻-type substrate. According to JP 2010171057, a structured anode region is provided in the FWD region. US 2008/048295 A1 relates to an insulated gate semiconductor device that integrates an IGBT and a diode in a single semiconductor substrate. According to US 2008/048295, a first P-type base region is provided in the IGBT region and a second P-type base region is provided in the diode region. A thickness of the first P-type base region is greater than a thickness of the second P-type base region. Moreover, impurity concentrations are different in the respective P-type base regions.

### SUMMARY

The object of the present invention is to provide a power semiconductor device, a related circuit, a chip, and an electronic device to reduce a reverse recovery loss of a diode. This object is solved by the attached independent claim and further embodiments and improvements of the invention are listed in the attached dependent claims.

According to a first aspect according to the invention, an embodiment of this application provides a semiconductor device. The semiconductor device is defined in claim 1 and includes:
a first-conductivity-type first semiconductor layer, where the first semiconductor layer includes a first surface and a second surface that are opposite to each other, an insulated gate bipolar transistor IGBT region used to form an IGBT, and a diode region used to form a diode;
a second-conductivity-type second semiconductor layer disposed on the first surface of the first semiconductor layer, where a thickness of the second semiconductor layer located in the IGBT region is greater than a thickness of the second semiconductor layer located in the diode region;
a first-conductivity-type emitter region disposed on a surface, of the second semiconductor layer located in the IGBT region, away from the first semiconductor layer; and
a collector layer and an electrode layer that are disposed on the second surface of the first semiconductor layer, where the collector layer and the electrode layer are respectively disposed relative to the IGBT region and the diode region.

The semiconductor device optimizes a front structure of the diode region, and reduces carrier concentration in the diode region by reducing a thickness of a semiconductor layer used as a positive electrode region or a negative electrode region in the region. In this way, front carrier injection efficiency when the diode is turned on is reduced, a reverse recovery charge amount when the diode is turned off is reduced, a reverse recovery loss Err is reduced, and switching efficiency of the RC-IGBT is finally improved.

For example, first-conductivity-type is N-type, and second-conductivity-type is P-type. Hole injection concentration in a positive electrode of the diode is reduced by reducing a thickness of a P-type second semiconductor layer in the region. In this way, a reverse recovery charge amount when the diode is turned off is reduced, a reverse recovery loss Err is reduced, and switching efficiency of the RC-IGBT is finally improved.

For another example, first-conductivity-type is P-type, and second-conductivity-type is N-type. Electron injection concentration in a negative electrode of the diode is reduced by reducing a thickness of an N-type second semiconductor layer. In this way, a reverse recovery charge amount when the diode is turned off is reduced, and a reverse recovery loss Err of the diode is reduced.

It should be understood that "front" in this embodiment of this application refers to a side, of the diode, near an emitter electrode. When the second semiconductor layer is of P-type, the front structure of the diode is the positive electrode region of the diode. On the contrary, when the second semiconductor layer is of N-type, the front structure of the diode is the negative electrode region of the diode.

In a possible implementation, the thickness of the second semiconductor layer located in the IGBT region is 0.5 to 3 micrometers, and the thickness of the second semiconductor layer located in the diode region is 0.5 to 2.5 micrometers.

In a possible implementation, a ratio of the thickness of the second semiconductor layer located in the diode region to the thickness of the second semiconductor layer located in the IGBT region is 0.2 to 0.8.

In a possible implementation, the second semiconductor layer located in the IGBT region includes a second-conductivity-type contact region, the semiconductor device includes a plurality of emitter regions disposed at intervals, the contact region is disposed between two adjacent emitter regions, and second-conductivity-type impurity concentration in the contact region is greater than second-conductivity-type impurity concentration in the second semiconductor layer.

The semiconductor device further optimizes the front structure of the diode region, and further reduces the carrier concentration in the diode region by removing the contact region in the diode region. In this way, the front carrier injection efficiency when the diode is turned on is reduced, the reverse recovery charge amount when the diode is turned off is further reduced, the reverse recovery loss Err is reduced, and the switching efficiency of the RC-IGBT is finally improved.

In a possible implementation, the second semiconductor layer located in the diode region does not include a second-conductivity-type contact region.

In a possible implementation, a difference between the thickness of the second semiconductor layer located in the IGBT region and the thickness of the second semiconductor layer located in the diode region is not less than a thickness of the contact region.

In a possible implementation, the semiconductor device further includes:
at least one gate electrode that penetrates the second semiconductor layer and that is in contact with the first semiconductor layer located in the IGBT region; and
a first insulation layer disposed between each gate electrode and the first semiconductor layer.

Optionally, one end of the gate electrode is substantially flush with a surface, of the emitter region, away from the first semiconductor layer.

In a possible implementation, the semiconductor device further includes:
at least one first electrode that penetrates the second semiconductor layer and that is in contact with the first semiconductor layer located in the diode region; and
a second insulation layer disposed between each first electrode and the first semiconductor layer.

Optionally, one end of the first electrode is substantially flush with the second semiconductor layer located in the diode region.

In a possible implementation, a first-conductivity-type carrier storage CS layer is further included between the IGBT region and the second semiconductor layer or between the first semiconductor layer and the second semiconductor layer.

In a possible implementation, the first semiconductor layer includes a first-conductivity-type pillar and a second-conductivity-type pillar that are arranged alternately along a first direction, the first direction is substantially perpendicular to a thickness direction, and both the first-conductivity-type pillar and the second-conductivity-type pillar extend along the thickness direction.

According to a second aspect according to the invention, an embodiment of this application further provides a power conversion circuit. The power conversion circuit includes at least the semiconductor device according to any one of the first aspect or the implementations of the first aspect.

The power conversion circuit is a circuit configured to implement functions such as adjusting frequency conversion, conversion, phase change, rectification, inversion, and switching of a voltage/current, and may be an inverter circuit, a rectifier, a converter circuit, or the like.

According to a third aspect according to the invention, an embodiment of this application further provides a reverse conduction insulated gate bipolar transistor RC-IGBT chip. The RC-IGBT chip includes at least the semiconductor device according to any one of the first aspect or the implementations of the first aspect.

According to a fourth aspect according to the invention, an embodiment of this application further provides an electronic device. The electronic device includes at least the semiconductor device according to any one of the first aspect or the implementations of the first aspect; or includes at least the RC-IGBT chip according to any one of the third aspect or the implementations of the third aspect.

According to a fifth aspect not claimed, an embodiment of this application further provides a semiconductor device preparation method. The method includes:
providing a first-conductivity-type substrate, where the substrate includes a first surface and a second surface that are opposite to each other, an insulated gate bipolar transistor IGBT region used to form an IGBT, and a diode region used to form a diode;
forming at least one gate electrode that is in contact with, through a first insulation layer, the substrate located in the IGBT region;
injecting a second-conductivity-type impurity ion into the first surface of the substrate, to form a second-conductivity-type semiconductor layer; and forming an emitter region and a contact region of the IGBT in the semiconductor layer disposed in the IGBT region; and
etching the semiconductor layer disposed in the diode region, where a thickness of the etched semiconductor layer disposed in the diode region is less than a thickness of the etched semiconductor layer disposed in the IGBT region.

According to the preparation method not claimed, a front structure of the diode region is optimized, and carrier concentration in the diode region is reduced by reducing a thickness of a semiconductor layer used as a positive electrode region or a negative electrode region in the region. In this way, front carrier injection efficiency when the diode is turned on is reduced, a reverse recovery charge amount when the diode is turned off is reduced, a reverse recovery loss Err is reduced, and switching efficiency of the RC-IGBT is finally improved.

In a possible implementation, the thickness of the etched second semiconductor layer disposed in the IGBT region is 0.5 to 3 micrometers, and the thickness of the etched second semiconductor layer disposed in the diode region is 0.5 to 2.5 micrometers.

In a possible implementation, a ratio of the thickness of the etched second semiconductor layer disposed in the diode region to the thickness of the etched second semiconductor layer disposed in the IGBT region is 0.2 to 0.8.

In a possible implementation, the forming an emitter region and a contact region of the IGBT in the semiconductor layer disposed in the IGBT region includes:
injecting a first-conductivity-type impurity ion into the semiconductor layer located on two sides of the gate electrode, to form the emitter region;
forming an insulation medium layer covering the emitter region, the gate electrode, and the semiconductor layer;
etching the insulation medium layer disposed in the IGBT region, to form at least one first groove, where the first groove penetrates the insulation medium layer and exposes a part of the emitter region; and
injecting the second-conductivity-type impurity ion into the emitter region exposed in the first groove, to form the contact region.

In a possible implementation, the forming an emitter region and a contact region of the IGBT in the semiconductor layer disposed in the IGBT region includes:
injecting a first-conductivity-type impurity ion into the semiconductor layer located on two sides of the gate electrode, to form the emitter region;
forming an insulation medium layer covering the emitter region, the gate electrode, and the semiconductor layer;
etching the insulation medium layer and a part of the emitter region that are disposed in the IGBT region, to form at least one second groove, where the second groove penetrates the insulation medium layer and the emitter region, and is configured to expose the semiconductor layer, and an etching depth of the emitter region disposed in the IGBT region is less than an etching depth of the semiconductor layer disposed in the diode region; and
injecting the second-conductivity-type impurity ion into the semiconductor layer exposed in the second groove, to form the contact region.

In a possible implementation, the etching the semiconductor layer disposed in the diode region includes:
forming a photoresist layer covering the contact region, the insulation medium layer, and the semiconductor layer;
partially exposing the photoresist layer by using a light cover, to form a mask, where the mask is configured to protect the emitter region, the contact region, and the insulation medium layer that are disposed in the IGBT region; and
etching the insulation medium layer and the semiconductor layer that are exposed by the mask.

In a possible implementation, the method further includes:
forming an emitter electrode covering the semiconductor layer, the insulation medium layer, and the contact region; and
forming an electrode layer of the diode and a collector layer on the second surface of the substrate.

In a possible implementation, the method further includes:
forming a CS layer between the substrate and the semiconductor layer; or forming a CS layer between the substrate located in the IGBT region and the semiconductor layer.

In a possible implementation, the method further includes: forming, in the substrate, a first-conductivity-type pillar and a second-conductivity-type pillar that are arranged alternately along a first direction, where the first direction is substantially perpendicular to a thickness direction, and both the first-conductivity-type pillar and the second-conductivity-type pillar extend along the thickness direction.

In a possible implementation, the method further includes:
forming at least one first electrode that is in contact with, through a second insulation layer, the substrate located in the diode region.

The method further includes:
etching the first electrode, the second insulation layer, and the insulation medium layer that are located in the diode region, where after the etching, one end of the first electrode and one end of the second insulation layer are both flush with the semiconductor layer located in the diode region.

### BRIEF DESCRIPTION OF DRAWINGS

The following briefly describes accompanying drawings used in descriptions of embodiments.
FIG. 1A is a schematic top view of a chip before and after integration in a conventional technology;
FIG. 1B is a schematic cross-sectional view of an RC-IGBT chip in a conventional technology;
FIG. 2A is a schematic diagram of an equivalent circuit of an RC-IGBT according to an embodiment of this application, the embodiment of FIG. 2A is not claimed but it is useful for understanding the invention;
FIG. 2B is a schematic diagram of a working state of an RC-IGBT according to an embodiment of this application, the embodiment of FIG. 2B is not claimed but it is useful for understanding the invention;
FIG. 3A to FIG. 3C are schematic cross-sectional views of some groove-type RC-IGBTs according to embodiments of this application;
FIG. 4 to FIG. 7 are schematic cross-sectional views of some other groove-type RC-IGBTs according to embodiments of this application;
FIG. 8 is a schematic cross-sectional view of a planar-gate-type RC-IGBT according to an embodiment of this application;
FIG. 9 is a schematic diagram of distribution of ohmic contact holes of an RC-IGBT according to an embodiment of this application;
FIG. 10 is schematic cross-sectional views of an FWD region of an RC-IGBT in a conventional technology and an FWD region of an RC-IGBT according to an embodiment of this application;
FIG. 11 is a schematic diagram of drift layer hole concentration distribution of an existing RC-IGBT and an RC-IGBT according to this application when an FWD is turned on;
FIG. 12 is a schematic illustrative diagram of reverse recovery charge amounts Qrr of an existing RC-IGBT and an RC-IGBT according to this application when an FWD is turned off;
FIG. 13 is a schematic flowchart of a semiconductor device preparation method according to an embodiment of this application, the embodiment of figure 13 is not claimed but it is useful for understanding the invention;
FIG. 14A to FIG. 14J are schematic cross-sectional views of a device formed in a semiconductor device preparation procedure according to an embodiment of this application, the embodiment of FIG. 14A to FIG. 14J is not claimed but it is useful for understanding the invention;
FIG. 15A to FIG. 15G are schematic cross-sectional views of another device formed in a semiconductor device preparation procedure according to an embodiment of this application, the embodiment of FIG. 15A to FIG. 15G is not claimed but it is useful for understanding the invention; and
FIG. 16A to FIG. 16C are schematic cross-sectional views of another still device formed in a semiconductor device preparation procedure according to an embodiment of this application, the embodiment of FIG. 16A to FIG. 16C is not claimed but it is useful for understanding the invention;

### DESCRIPTION OF EMBODIMENTS

First, some key terms in embodiments of this application are described.

### (1) N-type semiconductor

N (Negative)-type is electronic-type. A semiconductor that mainly performs electron conduction is referred to as the N-type semiconductor. The N-type semiconductor is obtained by doping an intrinsic semiconductor with a donor impurity. For example, pure silicon is doped with a small quantity of pentavalent elements (phosphorus, arsenic, or the like). When the phosphorus forms a covalent bond with a surrounding tetravalent silicon atom, an extra free electron is generated. N-type may be further classified into N+ type (highly doped N-type) and N- type (lightly doped N-type), and impurity concentration in an N+ type semiconductor is greater than impurity concentration in an N- type semiconductor. It should be understood that N+ type (highly doped N-type) and N- type (lightly doped N-type) are relative to each other.

### (2) P-type semiconductor

P (Positive)-type is hole-type. A semiconductor that mainly performs hole conduction is referred to as the P-type semiconductor. The P-type semiconductor is obtained by doping an intrinsic semiconductor with an acceptor impurity. For example, pure silicon is doped with a small quantity of trivalent elements (boron, indium, or the like). When the boron forms a covalent bond with a surrounding tetravalent silicon atom, there is a lack of an electron, resulting in a hole. P-type may be further classified into P+ type (highly doped P-type) and P- type (lightly doped P-type), and impurity concentration in a P+ type semiconductor is greater than impurity concentration in a P- type semiconductor.

### (3) Insulated gate bipolar transistor (IGBT)

The IGBT is a complex fully controlled voltage-driven power semiconductor device including a bipolar junction transistor (BJT) and an metal-oxide-semiconductor field-effect transistor (MOSFET). The IGBT is applicable to a converter system with a direct current voltage of 600 V and above, such as an alternating current motor, a frequency converter, a switching power supply, a lighting circuit, traction drive, and other fields.

### (4) Freewheeling diode (FWD) and fast recovery diode (FRD)

The FWD is a diode that freewheels when the IGBT is turned off in an inductive load switching circuit. The FRD is a diode having a fast reverse recovery speed.

### (5) Reverse conduction IGBT (RC-IGBT)

The RC-IGBT is an IGBT structure that integrates a diode that can freewheel when the IGBT is turned off.

### (6) IGBT type and parameter

Development of the IGBT goes through different stages. A first-generation IGBT is a punch through IGBT (PT-IGBT). The first-generation IGBT uses a planar gate structure, uses a thick P-type substrate with high doping concentration, and has an epitaxially growing N-type buffer and an epitaxially growing drift region. During reverse blocking, an electric field is distributed in a trapezoidal shape. However, the device has a low voltage withstand level, and a positive conduction voltage drop has a negative temperature characteristic, which is not conducive to parallel application.

A second-generation IGBT is a non punch through IGBT (NPT-IGBT). Features are as follows: The second-generation IGBT has a groove gate structure, and uses a lightly doped N-type substrate as a drift layer. A back collector layer is formed by injecting a P-type impurity. During reverse blocking, an electric field is distributed in a triangle shape. The device has a greatly improved voltage withstand level. However, a substrate thickness is continuously increased, and a conduction voltage drop and a switching loss are both large.

A third-generation IGBT is a field stop IGBT (FS-IGBT). An N-type field stop layer is added on the basis of a structure of the second-generation IGBT. During reverse blocking, an electric field is distributed in a trapezoidal shape. In this way, a substrate thickness is reduced while a sufficient voltage withstand level of the device is ensured, so that both a conduction voltage drop and a switching loss are greatly reduced, and a compromise relationship between the conduction voltage drop Vcesat and a turn-off loss Eoff is improved.

A fourth-generation IGBT is a refined FS-IGBT. The fourth-generation IGBT reduces a cell size, and optimizes back buffer distribution (for example, forms a deep buffer by injecting hydrogen), so that a substrate thickness is further reduced, and a compromise relationship between higher power density, a better conduction voltage drop Vcesat, and a turn-off loss Eoff is obtained.

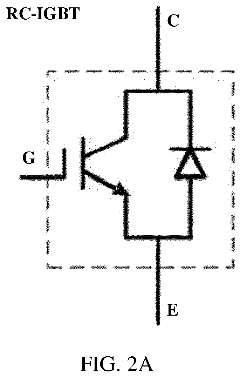

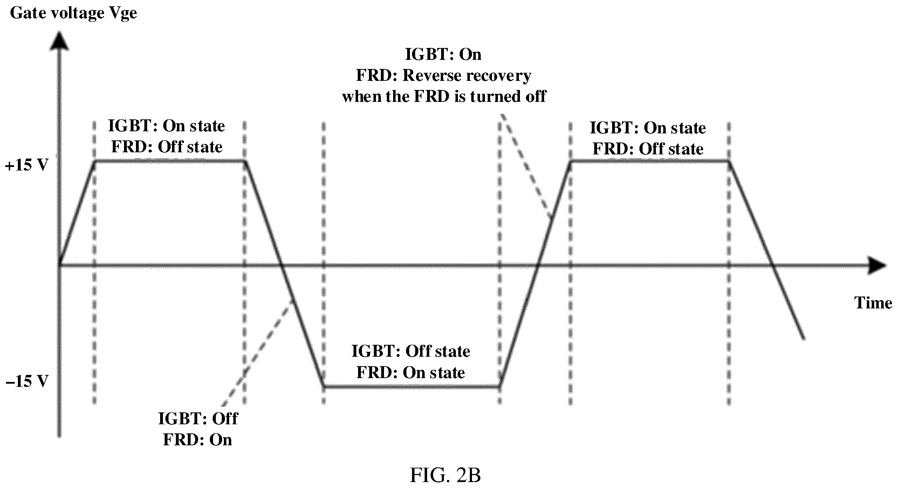

FIG. 2A shows an equivalent circuit of an RC-IGBT. An integrated FWD of the RC-IGBT is connected in reverse parallel to an integrated IGBT, and performs a freewheeling function when the IGBT is turned off. During actual working, as shown in FIG. 2B, an IGBT region and an FWD region of the RC-IGBT device are switched alternately. Therefore, to reduce a switching loss of the RC-IGBT device, both a reverse recovery loss Err when the integrated FWD is turned off and a switching loss Eon and Eoff of the integrated IGBT need to be optimized. However, to reduce the switching loss of the IGBT, an injection enhancement technology is usually used to increase concentration of front carriers near an emitter region. To reduce the reverse recovery loss of the FWD, front positive electrode carrier injection needs to be reduced. Consequently, when the RC-IGBT is designed, contradiction between IGBT carrier distribution and FWD carrier distribution needs to be resolved. This requires a design of an RC-IGBT that can reduce a reverse recovery loss of an FWD without increasing a switching loss of the IGBT. In addition, preparation costs of the RC-IGBT need to be reduced as much as possible. For example, a preparation process needs to be reduced.

Because in a conventional technology, except that injection of an emitter region is not performed, etching of a contact region, injection of a P-type semiconductor layer, injection of a P contact region, and the like in a structure of an FWD region of an RC-IGBT are the same as those of an IGBT region. As a result, hole injection efficiency of a positive electrode region of an FWD is excessively high, and an excess carrier that needs to be extracted during reverse recovery, namely, a reverse recovery charge amount Qrr when the diode is turned off, is excessively large. Finally, a reverse recovery loss Err is excessively high, affecting switching efficiency of the RC-IGBT.

To resolve the foregoing problem, embodiments of this application provide an RC-IGBT. The RC-IGBT optimizes a front structure of an FWD region, and reduces hole injection concentration in a positive electrode of an FWD by reducing a thickness of a P-type semiconductor layer in the region. In this way, front carrier injection efficiency when the diode is turned on is reduced, a reverse recovery charge amount when the diode is turned off is reduced, a reverse recovery loss Err of the diode is reduced, and switching efficiency of the RC-IGBT is finally improved.

It should be understood that the foregoing uses an RC-IGBT including an N-type drift layer as an example for description. For an IGBT including a P-type drift layer, a positive electrode of an FWD is an N-type semiconductor layer. Electron injection concentration in a negative electrode of the FWD is reduced by reducing a thickness of the N-type semiconductor layer, so that a reverse recovery loss Err is reduced.

The following describes an RC-IGBT in embodiments of this application. The RC-IGBT may also be referred to as a semiconductor device, a power semiconductor device, or the like. The RC-IGBT may have a structure of a PT-IGBT, an NPT-IGBT, or an FS-IGBT. The PT-IGBT is of a planar gate type, and the NPT-IGBT and the FS-IGBT each are of a groove type.

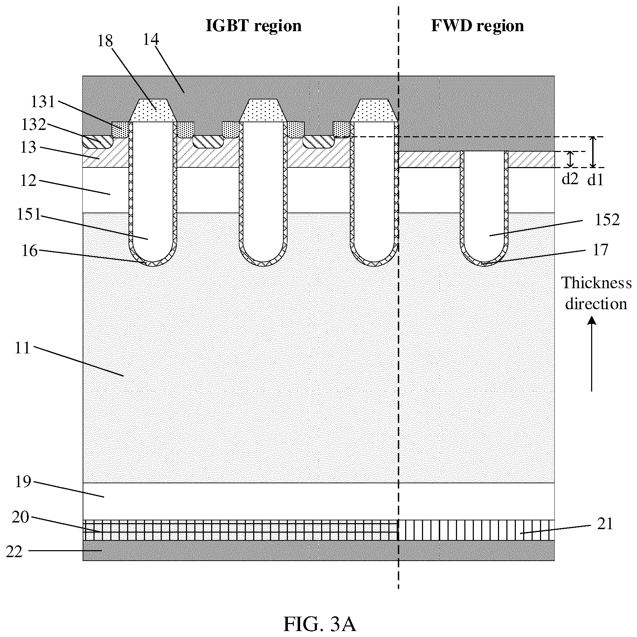

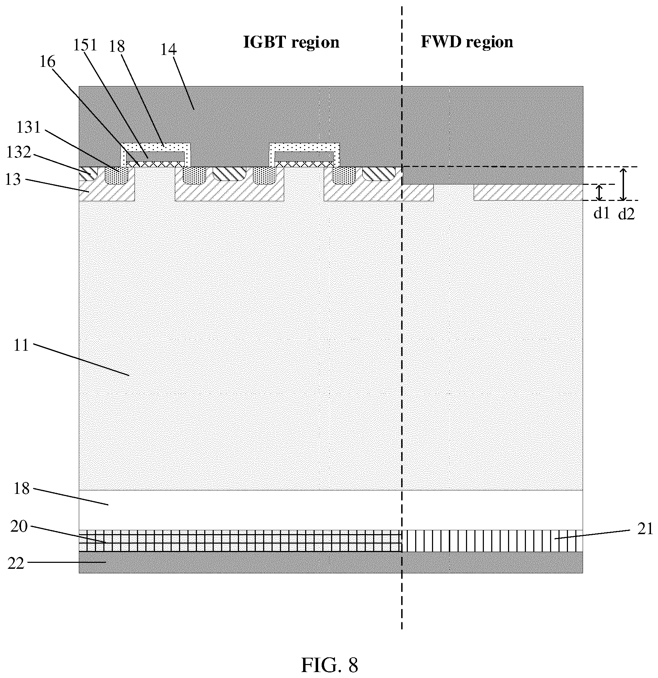

FIG. 3A to FIG. 3C and FIG. 4 to FIG. 8 are schematic cross-sectional views of some RC-IGBTs according to embodiments of this application. The RC-IGBTs shown in FIG. 3A to FIG. 3C and FIG. 4 to FIG. 7 each are of a groove type, and the RC-IGBT shown in FIG. 8 is of a planar gate type. The RC-IGBT may include a part or all of structures of a first-conductivity-type first semiconductor layer 11, a first-conductivity-type carrier store (CS) layer 12, a second-conductivity-type second semiconductor layer 13, a first-conductivity-type emitter region 131, a second-conductivity-type contact region 132, an emitter electrode 14, a gate electrode 151, a first electrode 152, a first insulation layer 16, a second insulation layer 17, an insulation medium layer 18, a buffer layer 19, a second-conductivity-type collector layer 20, a first-conductivity-type electrode layer 21, a collector electrode 22, and the like that are disposed in a stacked manner. In embodiments of this application, an example in which first-conductivity-type is N-type and second-conductivity-type is P-type is used for description. In this case, the electrode layer 21 belongs to a negative electrode of a diode. It may be understood that first-conductivity-type may alternatively be P-type, and second-conductivity-type may alternatively be N-type. In this case, the electrode layer 21 belongs to a positive electrode of a diode.

The RC-IGBT may be divided into an IGBT region and a diode region. For example, the diode is an FWD. In this case, the diode region is also referred to as an FWD region. It should be understood that the diode may alternatively be another type of diode. The IGBT region forms an IGBT device, and the FWD region forms an FWD. An N-channel IGBT is used as an example. An emitter electrode of the IGBT is shared with a positive electrode of the FWD, a Pbody layer of the IGBT is shared with a P region of the FWD, and an N-type drift layer of the IGBT is shared with an N region of the FWD.

The N-type first semiconductor layer 11 is also referred to as an N-type drift layer or an N--type drift layer. The N-type drift layer includes a first surface and a second surface that are opposite to each other.

The P-type second semiconductor layer 13 disposed on the first surface of the N-type first semiconductor layer 11 is also referred to as a Pbody layer, and is disposed on the first surface of the N-type drift layer. The P-type second semiconductor layer 13 may be formed by injecting a P-type impurity ion into the N-type drift layer or growing a P-type semiconductor. It should be understood that the P-type second semiconductor layer located in the IGBT region provides a channel when the IGBT works, and may also be referred to as a P-type channel layer; and the P-type second semiconductor layer located in the FWD region is a P region of the FWD, and is also referred to as a P region or a positive electrode region.

A thickness d1 of the second semiconductor layer 13 located in the IGBT region is greater than a thickness d2 of the second semiconductor layer 13 located in the FWD region, to reduce carrier concentration in the second semiconductor layer 13 located in the FWD region. In this way, front carrier injection efficiency when the diode is turned on is reduced, a reverse recovery charge amount when the diode is turned off is reduced, a reverse recovery loss Err is reduced, and switching efficiency of the RC-IGBT is finally improved.

For example, the thickness of the second semiconductor layer 13 located in the IGBT region is 0.5 to 3 micrometers, and the thickness of the second semiconductor layer 13 located in the diode region is 0.5 to 2.5 micrometers.

For another example, a ratio of the thickness of the second semiconductor layer 13 located in the diode region to the thickness of the second semiconductor layer 13 located in the IGBT region is 0.1 to 0.9 or 0.2 to 0.8. Optionally, the ratio is 0.5 or 0.6.

A plurality of emitter regions 131 disposed at intervals are disposed on a surface, of the second semiconductor layer 13, away from the first semiconductor layer 11. The emitter regions 131 exist only in the IGBT region. The N-type emitter region 131 may be obtained by injecting an N-type impurity ion into the second semiconductor layer 13 located on two sides of the gate electrode 151. The surface, of the second semiconductor layer 13, away from the first semiconductor layer 11 may include a plurality of contact regions 132. The contact region 132 may be located between two adjacent emitter regions 131, and is used for ohmic contact between the second semiconductor layer 13 and the emitter electrode 14. It may be understood that impurity ion concentration in the contact region 132 is usually higher than that in the second semiconductor layer 13.

As shown in FIG. 3A, the emitter region 131 may be higher than the contact region 132 in a thickness direction.

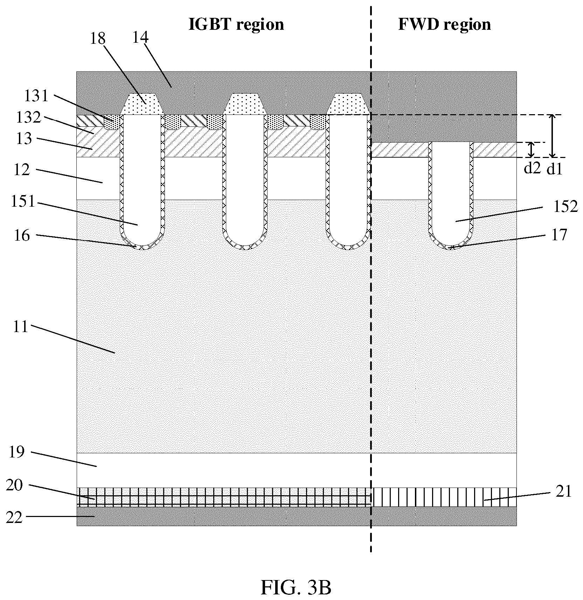

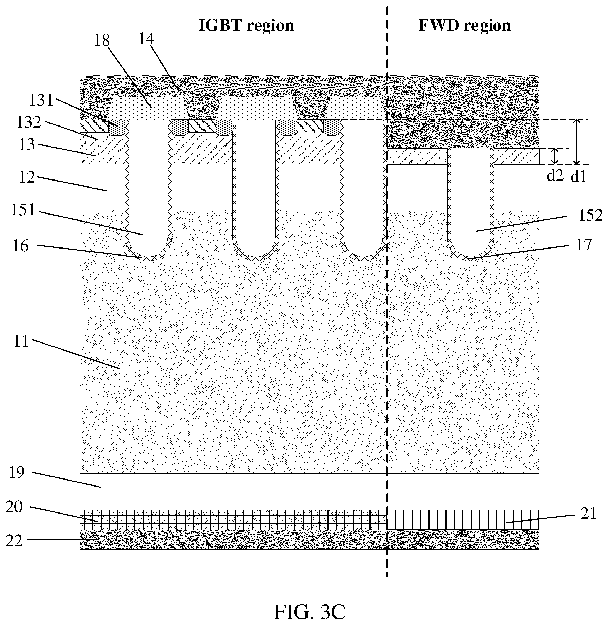

As shown in FIG. 3B and FIG. 3C, one end, of the emitter region 131, adjacent to the emitter electrode 14 may be substantially flush with the insulation medium layer 18. The "substantially flush with" means that a difference between average heights in a thickness direction is not large, for example, a difference is less than 1 nm.

In the RC-IGBTs shown in FIG. 3A to FIG. 3C and FIG. 5 to FIG. 7, the contact region 132 exists only in the IGBT region. For example, during preparation, injection may be performed only in the IGBT region to form the contact region 132.

Optionally, a difference between the thickness of the second semiconductor layer 13 located in the IGBT region and the thickness of the second semiconductor layer 13 located in the FWD region is not less than a thickness of the contact region 132. During preparation, a P-type impurity ion may be injected into a part of the P-type second semiconductor layer 13 located in the IGBT region and a part of the P-type second semiconductor layer 13 located in the FWD region, to form the contact region 132. In this way, the second semiconductor layer 13 and the contact region 132 that are located in the FWD region are etched under protection of the emitter region 131 by a mask, so that the contact region 132 located in the FWD region is completely etched. Therefore, carrier concentration in the positive electrode region in the FWD region is reduced, so that the reverse recovery charge amount and the reverse recovery loss Err are reduced.

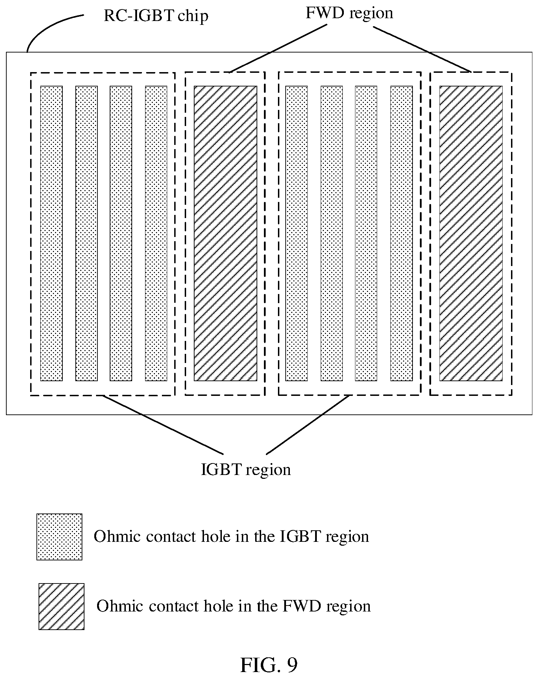

As shown in FIG. 9, an example in which a chip including the RC-IGBT shown in FIG. 3A includes two RC-IGBTs, and each RC-IGBT includes four IGBTs and one FWD is used. FIG. 9 is a schematic diagram of distribution of ohmic contact holes of the second semiconductor layer 13. The ohmic contact hole located in the IGBT region is formed by the contact region 132; and the contact region located in the IGBT region is formed by the second semiconductor layer 13 and the first electrode 152 in the region. It can be learned that the ohmic contact hole located in the IGBT region is narrower in width, and is located between the gate electrodes 151; and the ohmic contact hole located in the FWD region is wide in width, and the width of the ohmic contact hole is the width of the FWD region.

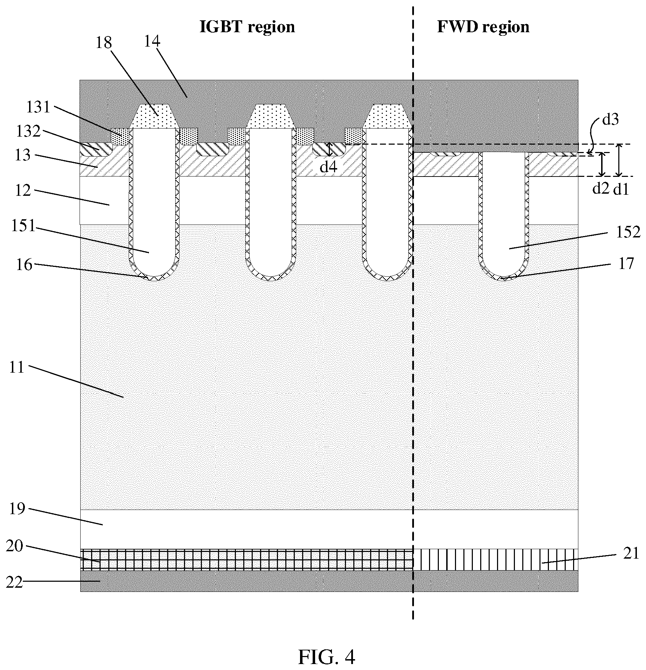

As shown in FIG. 4, the P-type second semiconductor layer 13 in the FWD region may include the contact region 132. In this case, a thickness d3 of the contact region 132 located in the FWD region may be less than a thickness d4 of the contact region 132 located in the IGBT region, so that carrier concentration in the contact region 132 located in the FWD region is reduced. In this case, a reverse recovery charge amount when the diode is turned off is reduced, a reverse recovery loss Err is reduced, and switching efficiency of the RC-IGBT is finally improved.

Optionally, in the RC-IGBTs shown in FIG. 3A to FIG. 3C, FIG. 4 and FIG. 5, the carrier storage (CS) layer 12 may be further included between the N-type first semiconductor layer 11 and the P-type second semiconductor layer 13. The CS layer 12 exists in both the IGBT region and the FWD region. For the N-type first semiconductor layer 11, an impurity ion of a same conductivity type as the drift layer may be injected into the CS layer 12. For the N-type first semiconductor layer 11 (N-type drift layer), the N-type CS layer 12 may form a hole barrier, to prevent the hole from being pulled out by the emitter when the IGBT is turned on, and improve injection efficiency of the drift layer near the emitter. In this way, conductivity modulation during conduction is increased, and a saturation voltage can be reduced.

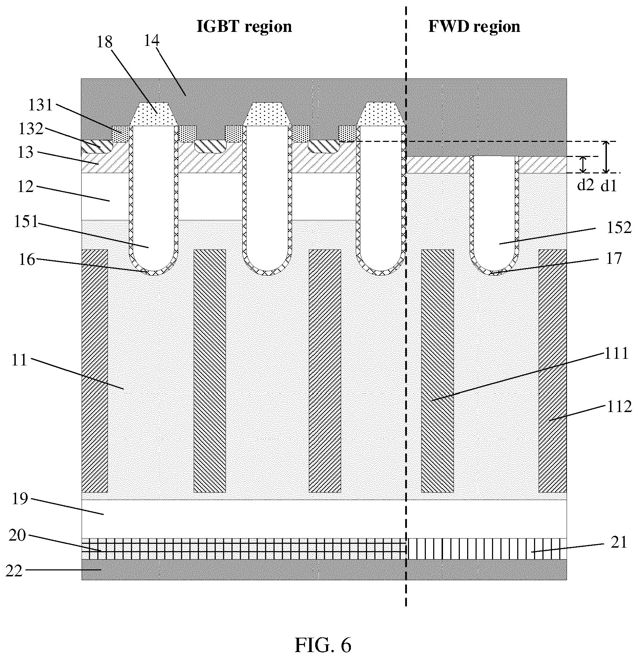

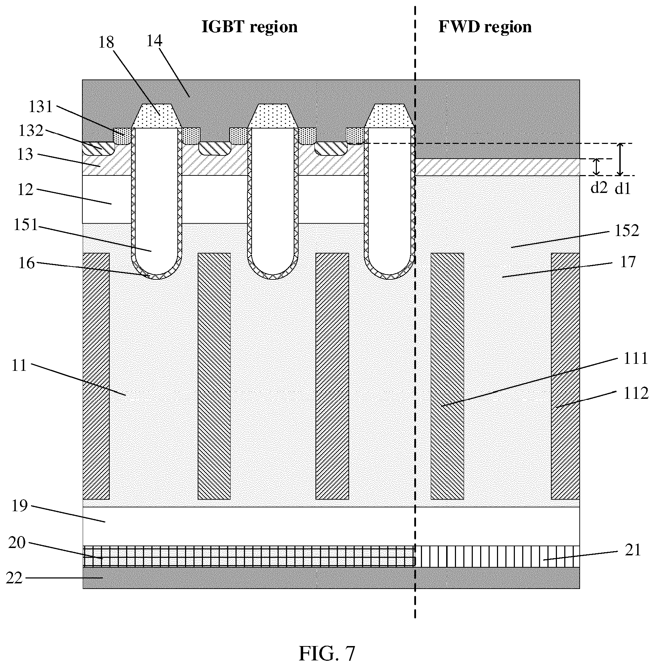

For the RC-IGBTs shown in FIG. 6 and FIG. 7, in some embodiments, the CS layer 12 exists only in the IGBT region, and the first semiconductor layer 11 located in the FWD region is in direct contact with the second semiconductor layer 13 located in the FWD region. It should be understood that the CS layer 12 is not a necessary layer structure of the RC-IGBT. In some embodiments, the RC-IGBT may not include the CS layer.

The groove-type RC-IGBTs shown in FIG. 3A to FIG. 3C and FIG. 4 to FIG. 7 each further include a plurality of gate electrodes 151, a first insulation layer 16, an insulation medium layer 18, and an emitter electrode 14. The plurality of gate electrodes 151 penetrate the second semiconductor layer 13 and the CS layer 12. One end of the gate electrode 151 is inserted into the first semiconductor layer 11 (drift layer). The first insulation layer 16 is included between each gate electrode 151 and each of the second semiconductor layer 13, the CS layer 12, and the first semiconductor layer 11. The other end of the gate electrode 151 is covered by the insulation medium layer 18. The RC-IGBT further includes the emitter electrode 14. The emitter electrode 14 is in contact with each emitter region 151 and each contact region 152. The insulation medium layer 18 is configured to isolate the gate electrode 151 from the emitter electrode 14.

It should be understood that the insulation medium layer 18 may further cover or partially cover the emitter region 131, as shown in FIG. 3C. When the emitter region 131 is isolated from the emitter electrode 14 by the insulation medium layer 18, the emitter region 131 and the emitter electrode 14 may be electrically connected on a side surface of the device.

Optionally, the groove-type RC-IGBTs shown in FIG. 3A to FIG. 3C and FIG. 4 to FIG. 6 each further include at least one first electrode 152 and a second insulation layer 17. Each first electrode 152 penetrates the second semiconductor layer 13 and the CS layer 12. One end of the first electrode 152 is inserted into the first semiconductor layer 11 (drift layer). The second insulation layer 17 is included between each first electrode 152 and each of the second semiconductor layer 13, the CS layer 12, and the first semiconductor layer 11.

Optionally, the gate electrode 151 and the first electrode 152 may be generated by using a same process. An electrode located in the IGBT region is referred to as the gate electrode 151, and an electrode located in the FWD region is referred to as the first electrode 152. When the second semiconductor layer 13 is etched, the first electrode 152 located in the FWD region is also etched, so that the other end of the first electrode 152 is flush with the second semiconductor layer 13 located in the FWD region. It should be noted that the first electrode 152 located in the FWD region may alternatively not be etched. This is not limited herein.

It should be understood that, for the P-channel IGBT, the first electrode 152 located in the FWD region is electrically connected to the emitter electrode 14, and may function as a positive electrode.

For the groove-type RC-IGBT shown in FIG. 7, in some embodiments, the FWD region may not include the first electrode 152 and the second insulation layer 17.

In some embodiments, the RC-IGBT further includes a buffer layer 19 (also referred to as a field stop layer), a collector layer 20, and an electrode layer 21 that are disposed on the second surface of the first semiconductor layer 11. Usually, the buffer layer 19 and the first semiconductor layer 11 are of a same conductivity type, and impurity ion concentration in the buffer layer 19 is greater than that in the first semiconductor layer. Therefore, for the N-type first semiconductor, the buffer layer 19 is also referred to as an N+ type buffer layer or an N+ type field stop layer.

The buffer layer 19 is not a necessary layer structure, and both the collector layer 20 and the electrode layer 21 are configured to provide ohmic contact.

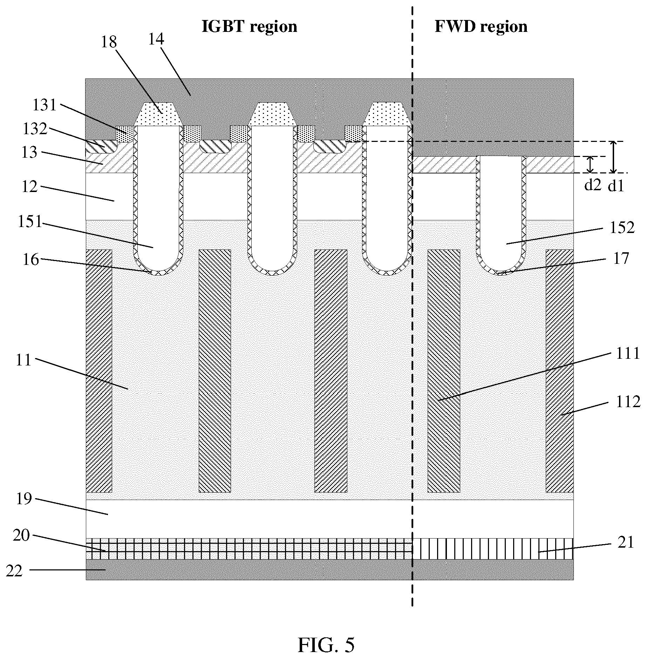

For the groove-type RC-IGBTs shown in FIG. 5 to FIG. 7, in some embodiments, an N-type pillar 111 and a P-type pillar 112 that are arranged alternately along a first direction are disposed on the first-conductivity-type first semiconductor layer 11, and both the N-type pillar 111 and the P-type pillar 112 extend along a thickness direction of the first semiconductor layer 11, to form a structure of a super-junction drift region. When the device of this structure is working, the N-type pillar 111 and the P-type pillar 112 are exhausted each other, which is equivalent to reducing effective doping concentration in the drift region, so that a voltage withstand level of the device is improved. The first direction is perpendicular or substantially perpendicular to the thickness direction of the device. It should be understood that "substantially perpendicular" may be regarded as that an angle is about 90°. For example, an angle range is 85° to 105° or 80° to 110°.

For the planar-gate-type RC-IGBT shown in FIG. 8, the first semiconductor layer 11 of the device includes grooves disposed at intervals. The P-type second semiconductor layer 13 is disposed in the grooves. The P-type second semiconductor layer 13 located in the grooves is referred to as a P well region. An N+ type emitter region 131 and a P+ type contact region 132 are disposed in the P well region located in the IGBT region. The gate electrodes 151 are disposed on the first surface of the first semiconductor layer 11 at intervals, and a first insulation layer 16 is included between the gate electrode 151 and the first semiconductor layer 11.

A thickness d1 of the second semiconductor layer 13 located in the IGBT region is greater than a thickness d2 of the second semiconductor layer 13 located in the FWD region, and the second semiconductor layer 13 located in the FWD region does not include the contact region 132, to reduce carrier concentration in the second semiconductor layer 13 located in the FWD region. In this way, front carrier injection efficiency when the diode is turned on is reduced, a reverse recovery charge amount when the FWD is turned off is reduced, a reverse recovery loss Err is reduced, and switching efficiency of the RC-IGBT is finally improved.

For the RC-IGBT including the N-type first semiconductor layer, when a voltage V_{GS} applied between the gate electrode and the emitter electrode is greater than a critical value V_{GES}, a channel that conducts the emitter region and the first semiconductor layer (namely, the drift layer) may be formed at a position, of the second semiconductor layer 13, adjacent to the gate electrode.

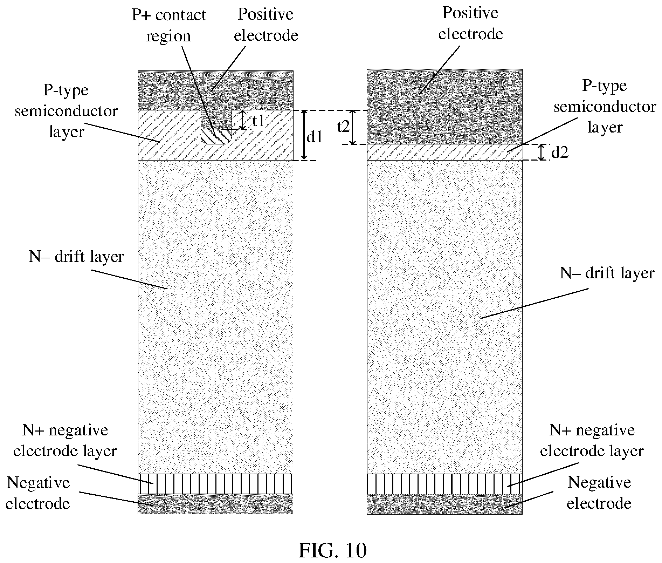

In FIG. 10, an N-channel RC-IGBT is used as an example to compare schematic cross-sectional views of an FWD region of an RC-IGBT in a conventional technology and an FWD region of an RC-IGBT according to an embodiment of this application. A collector electrode located in the FWD region is also referred to as a negative electrode, and an emitter electrode located in the FWD region is also referred to as a positive electrode. In the conventional technology, a thickness d1 of a P-type semiconductor layer in the FWD region is equal to that in an IGBT region, and is greater than a thickness d2 of a P-type semiconductor layer in the FWD region of the RC-IGBT according to this embodiment of this application. In this case, in a preparation process, when a P+ contact region is formed through etching, an etching depth t1 of the P-type semiconductor layer in the conventional technology may be less than an etching depth t2 of the P-type semiconductor layer in this embodiment of this application. In addition, etching performed on the P-type semiconductor layer in this embodiment of this application may be etching performed on the entire FWD region, to reduce carrier concentration in the P-type semiconductor layer in the FWD region. In this way, a reverse recovery charge amount Qrr when the diode is turned off is reduced, a reverse recovery loss Err is reduced, and switching efficiency of the RC-IGBT is finally improved.

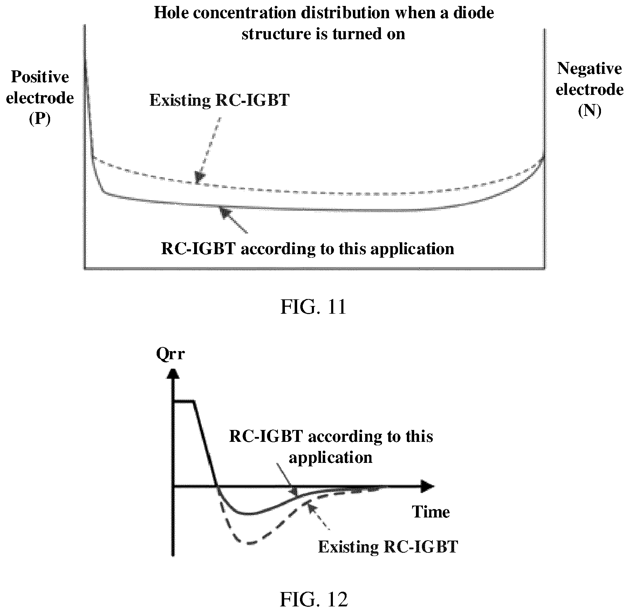

FIG. 11 is a schematic diagram of drift layer hole concentration distribution of an existing RC-IGBT and an RC-IGBT according to this application when an FWD is turned on. It can be learned that, when the FWD is turned on, the drift layer hole concentration in the RC-IGBT according to this application is less than that in the existing RC-IGBT.

FIG. 12 is a schematic illustrative diagram of reverse recovery charge amounts Qrr of an existing RC-IGBT and an RC-IGBT according to this application when an FWD is turned off. It can be learned that, when the FWD is turned off, the reverse recovery charge amount Qrr of the RC-IGBT according to this application is less than that of the existing RC-IGBT.

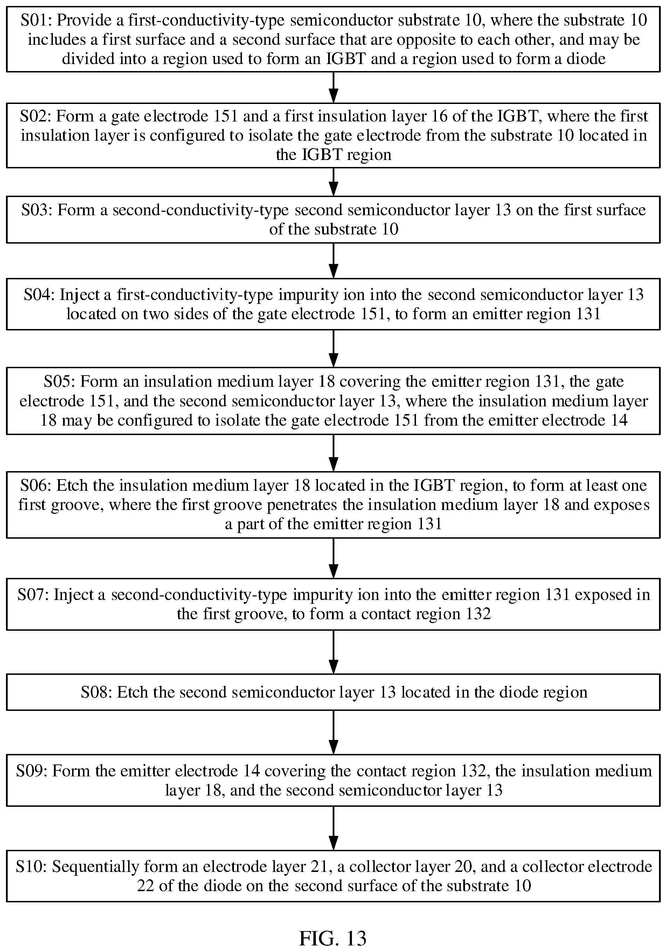

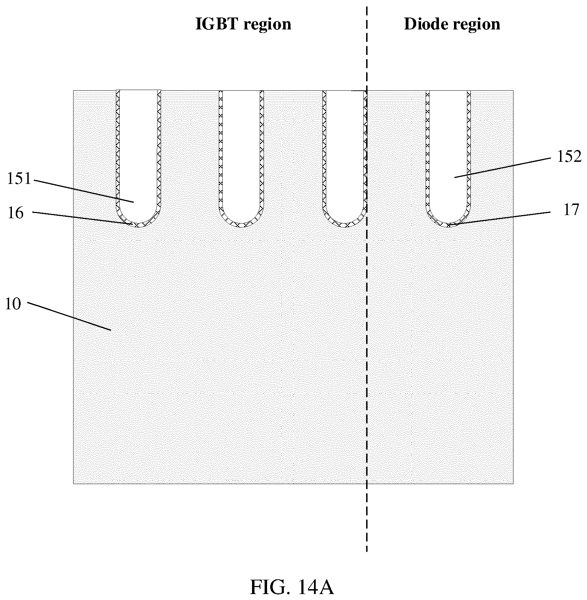

The following describes a method for preparing the RC-IGBTs shown in FIG. 3A to FIG. 3C and FIG. 4 to FIG. 8. FIG. 13 is a schematic flowchart of an RC-IGBT preparation method. As shown in FIG. 13 and FIG. 14A to FIG. 14H, the preparation method may include but is not limited to a part or all of the following steps.

S01: Provide a first-conductivity-type semiconductor substrate 10, where the substrate 10 includes a first surface and a second surface that are opposite to each other, and may be divided into a region used to form an IGBT and a region used to form a diode, which are referred to as an IGBT region and a diode region respectively.

It should be understood that, the substrate 10 corresponds to the first semiconductor layer 11 in the RC-IGBT, and is a drift layer of the device after preparation.

In some embodiments, an N-type pillar and a P-type pillar that are arranged alternately along a first direction may be formed in the substrate 10, to form a structure of a super-junction drift region. The first direction is perpendicular or substantially perpendicular to a thickness direction of the device, and both the N-type pillar and the P-type pillar extend along the thickness direction.

S02: Form a gate electrode 151 and a first insulation layer 16 of the IGBT, where the first insulation layer is configured to isolate the gate electrode from the substrate 10 located in the IGBT region.

As shown in FIG. 14A, when a groove-type RC-IGBT is prepared, the substrate 10 may be etched by using a photoetching process, to form a plurality of grooves, where the grooves are used to expose the substrate 10. Then, a first insulation material and a first metal are sequentially deposited in the grooves. The first metal located in the IGBT region is referred to as the gate electrode 151, and the first insulation material located between the gate electrode 151 and the substrate 10 is the first insulation layer 16; and the first metal located in the diode region is referred to as a first electrode 152, and the first insulation material located between the first electrode 152 and the substrate 10 is a second insulation layer 17.

It should be understood that, the first electrode 152 and the second insulation layer 17 are not necessary structures of the RC-IGBT. In some other embodiments, the first electrode 152 and the second insulation layer 17 may not be formed.

When a planar-gate-type RC-IGBT is prepared, a first insulation material and a first metal may be sequentially deposited on the first surface of the substrate 10, to form a first insulation material layer and a first metal layer that are sequentially stacked on a second semiconductor layer. Then, the first insulation material layer and the first metal layer are patterned by using a photoetching process, to obtain the gate electrode, the first insulation layer, the first electrode, and the second insulation layer. It may be understood that, the first metal layer located in the IGBT region is referred to as the gate electrode, and the first insulation material layer located between the gate electrode and the substrate 10 is the first insulation layer; and the first metal layer located in the diode region is referred to as a first electrode, and the first insulation material layer located between the first electrode and the substrate 10 is a second insulation layer.

S03: Form a second-conductivity-type second semiconductor layer 13 on the first surface of the substrate 10.

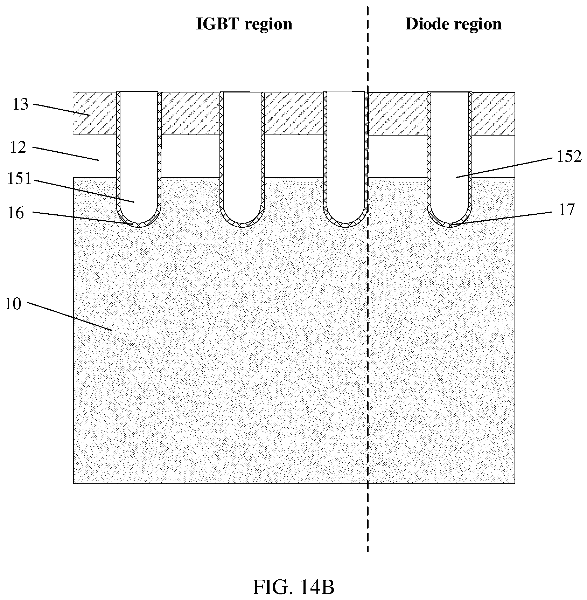

As shown in FIG. 14B, when the groove-type RC-IGBT is prepared, a first-conductivity-type impurity ion and a second-conductivity-type impurity ion may be injected into two sides of the gate electrode 151 on the first surface of the substrate 10. An injection depth of the first-conductivity-type impurity ion is greater than that of the second-conductivity-type impurity ion. In this way, a region in which the first-conductivity-type impurity ion is injected into the substrate 10 is the CS layer, and a region in which the second-conductivity-type impurity ion is injected into the substrate 10 is a second semiconductor layer 13.

It may be understood that the CS layer 12 is not a necessary layer structure of the RC-IGBT. In some other embodiments, the CS layer 12 may not be formed.

In some embodiments, the first-conductivity-type impurity ion may be injected only into the substrate 10 located in the IGBT region. That is, the CS layer 12 is formed only in the IGBT region.

It should be understood that, when the planar-gate-type RC-IGBT is prepared, a second-conductivity-type impurity ion may be injected into a plurality of regions on the first surface of the substrate 10, to form a plurality of second-conductivity-type well regions, where the plurality of second-conductivity-type well regions are the second semiconductor layer.

In some other embodiments, the CS layer 12 and the second semiconductor layer 13 may be sequentially deposited and grown on the first surface of the substrate 10, and then the groove-type gate electrode 151 and the groove-type first electrode 152 are formed.

S04: Inject the first-conductivity-type impurity ion into the second semiconductor layer 13 located on two sides of the gate electrode 151, to form an emitter region 131.

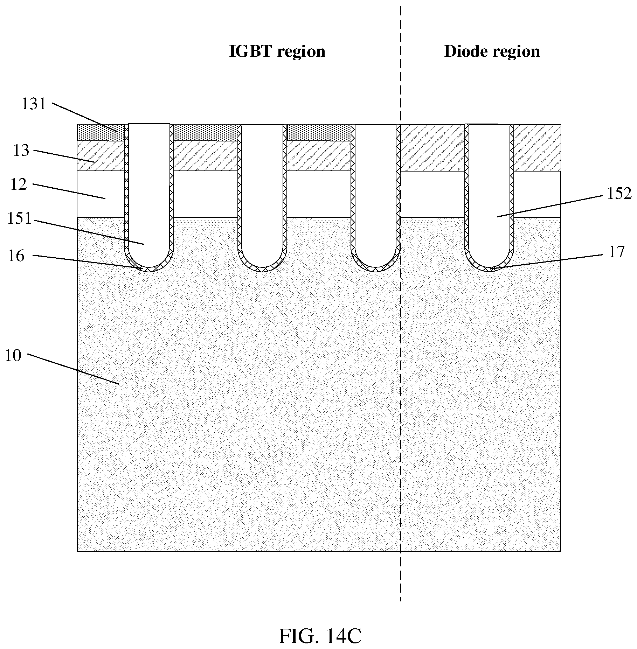

As shown in FIG. 14C, the first-conductivity-type impurity ion may be injected only into a surface of the second semiconductor layer 13 located in the IGBT region, to form the emitter region 131. A thickness of the emitter region 131 is less than a thickness of the second semiconductor layer 13.

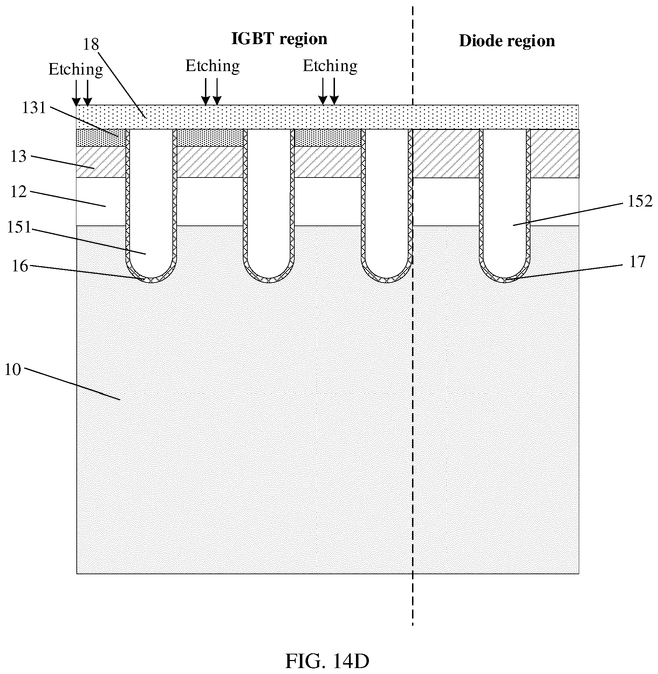

S05: Form an insulation medium layer 18 covering the emitter region 131, the gate electrode 151, and the second semiconductor layer 13, where the insulation medium layer 18 may be configured to isolate the gate electrode 151 from the emitter electrode 14, as shown in FIG. 14D.

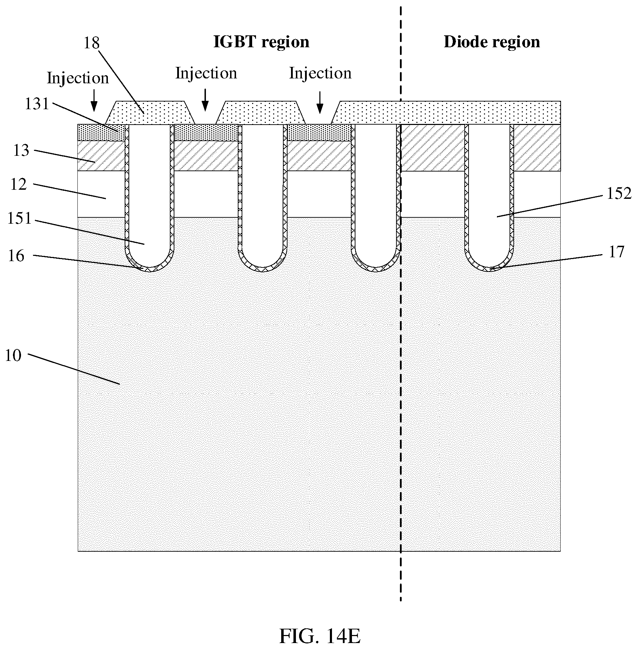

S06: Etch the insulation medium layer 18 located in the IGBT region, to form at least one first groove, where the first groove penetrates the insulation medium layer 18 and exposes a part of the emitter region 131, as shown in FIG. 14D and FIG. 14E.

Specifically, a first photoresist layer covering the insulation medium layer 18 may be first formed, and the first photoresist layer is partially exposed by using a light cover, to form a first mask. The first mask is configured to protect the insulation medium layer 18. Further, the insulation medium layer 18 exposed by the first mask is etched to a first depth, to form the first groove.

S07: Inject the second-conductivity-type impurity ion into the emitter region 131 exposed in the first groove, to form the contact region 132.

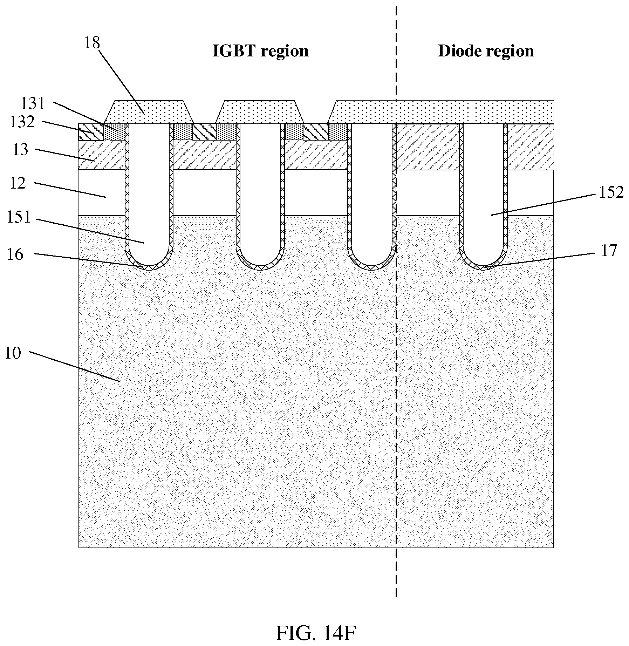

As shown in FIG. 14F, in some embodiments, the second-conductivity-type impurity ion may be injected into a surface of the second semiconductor layer 13 that is located in the IGBT region and that is exposed in the first groove, to form the contact region 132. In this case, the contact region 132 is located only in the IGBT region.

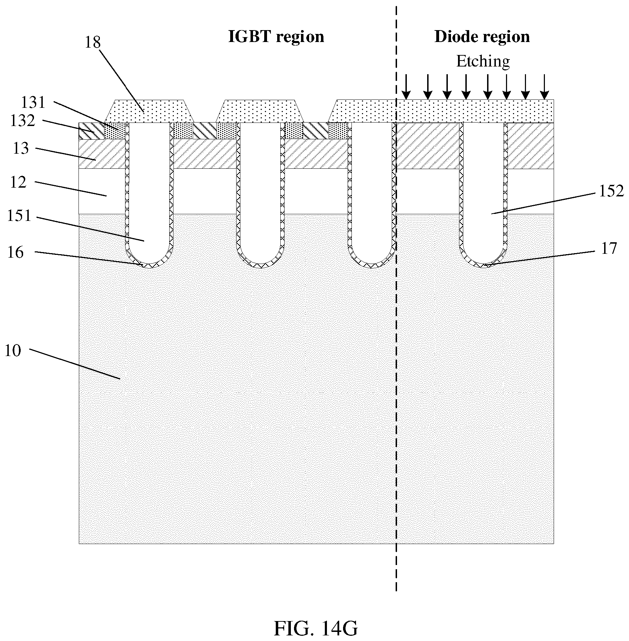

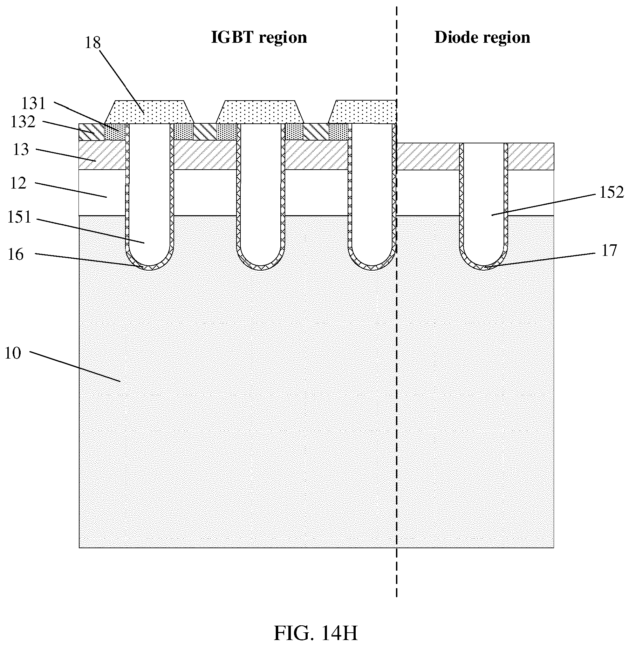

S08: Etch the second semiconductor layer 13 located in the diode region, as shown in FIG. 14G and FIG. 14H.

Specifically, a second photoresist layer covering the contact region 132 and the insulation medium layer may be first formed, and the second photoresist layer is partially exposed by using a light cover, to form a second mask. The second mask is configured to protect the emitter region 131, the contact region 132, the insulation medium layer 18, and the like that are located in the IGBT region. Further, the insulation medium layer 18 and the second semiconductor layer 13 that are located in the diode region and that are exposed by the second mask are etched, to reduce a thickness of the second semiconductor layer 13 in the diode region. It should be understood that, when the diode region includes the first electrode 152 and the second insulation layer 17, the first electrode 152 and the second insulation layer 17 may also be etched. One end, of the etched first electrode, adjacent to the emitter electrode 14 and one end, of the etched second insulation layer 17, adjacent to the emitter electrode 14 both are substantially flush with an etched semiconductor layer located in the diode region or higher than the etched semiconductor layer located in the diode region.

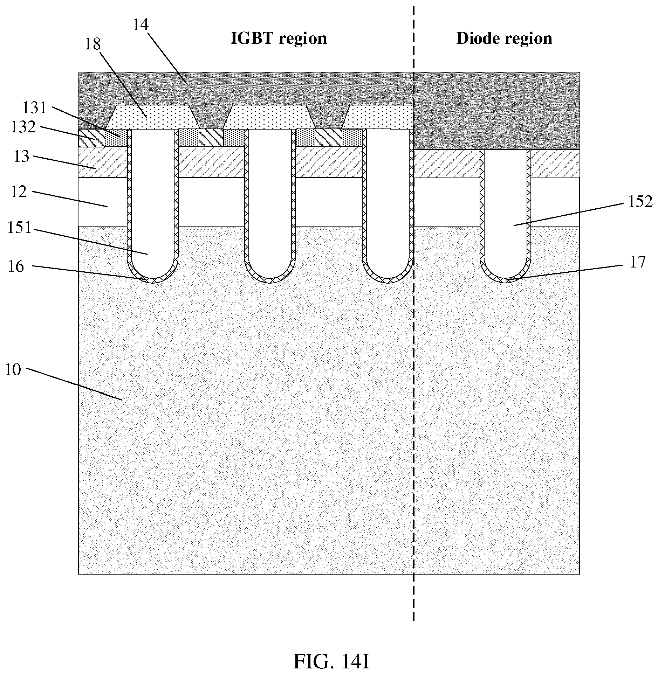

S09: Form the emitter electrode 14 covering the contact region 132, the insulation medium layer 18, and the second semiconductor layer 13, as shown in FIG. 14I.

In some embodiments, the insulation medium layer 18 located on a surface of the emitter region 131 may also be etched off, so that the emitter region 131 is in contact with the emitter electrode 14, to implement an electrical connection between the emitter region 131 and the emitter electrode 14.

When the emitter region 131 is isolated from the emitter electrode 14 by the insulation medium layer 18, the emitter region 131 and the emitter electrode 14 may be electrically connected on a side surface of the device.

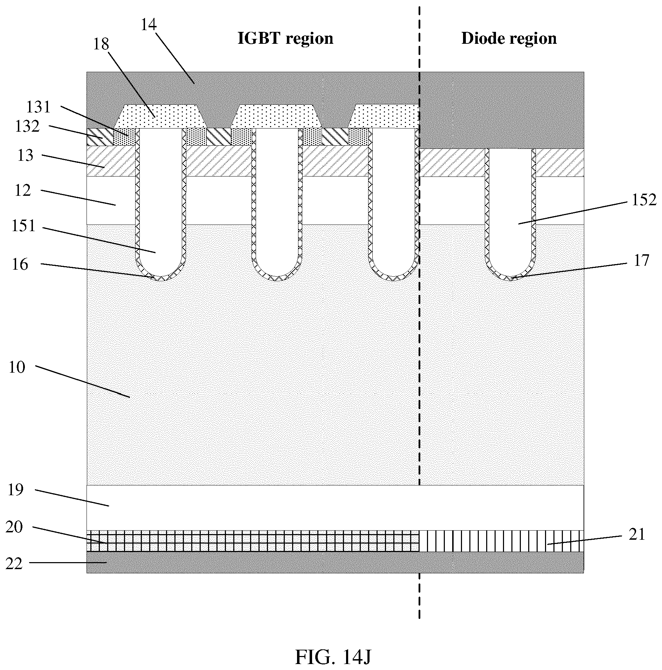

S10: Sequentially form an electrode layer 21, a collector layer 20, and a collector electrode 22 of the diode on the second surface of the substrate 10, as shown in FIG. 14J.

In some embodiments, the first-conductivity-type impurity ion may be injected into the second surface of the substrate 10, to form a buffer layer 19. The second-conductivity-type impurity ion may be further injected into the IGBT region, to form the collector layer 20, and the first-conductivity-type impurity ion may further be injected into the diode region, to form the electrode layer 21. Usually, impurity ion concentration in the buffer layer 19 is greater than that in the substrate 10.

An injection depth of the impurity ion forming the buffer layer 19 is greater than injection depths of the impurity ions forming the collector layer 20 and the electrode layer 21, to form a structure shown in FIG. 14J. Further, a metal layer covering the electrode layer 21 and the collector layer 20 is formed, to obtain the collector electrode 22.

It should be understood that another manner of preparing the buffer layer 19, the electrode layer 21, and the collector layer 20 may be further included. For example, a buffer layer, a second electrode layer, and a collector layer are grown on the surface of the substrate 10.

It should be further understood that the buffer layer 19 is not a necessary layer structure of the RC-IGBT. In some other embodiments, the buffer layer 19 may not be included.

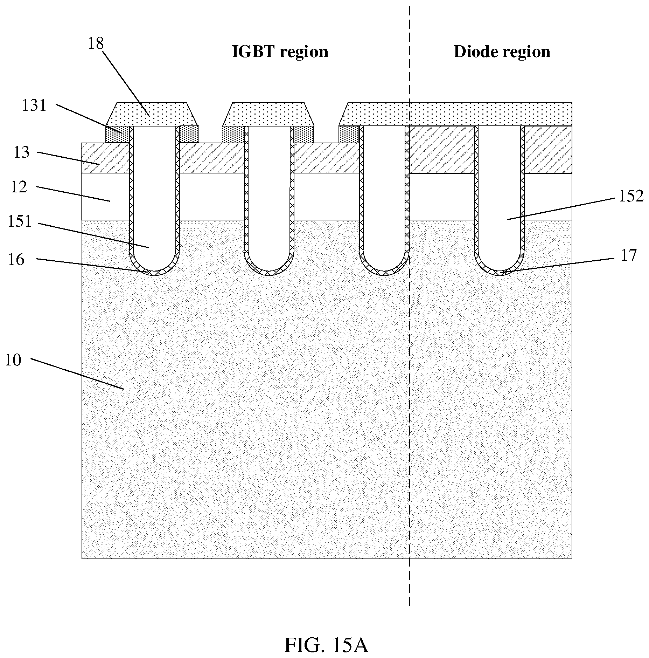

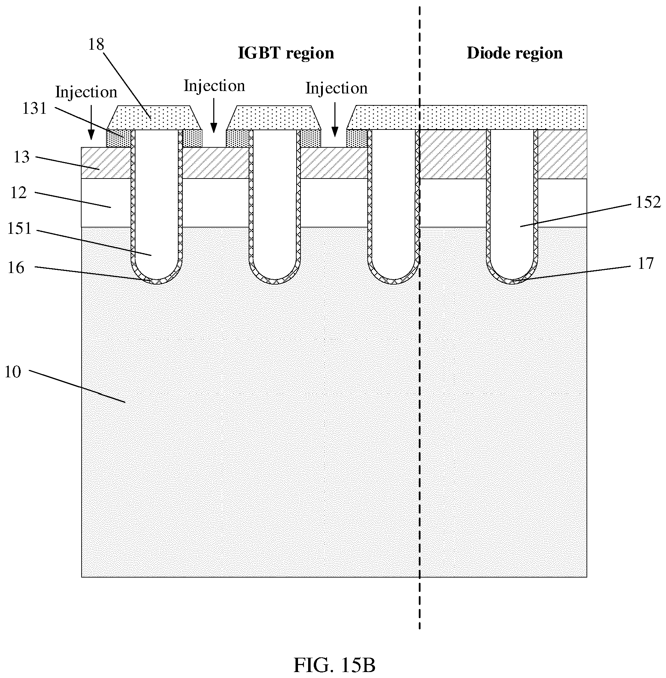

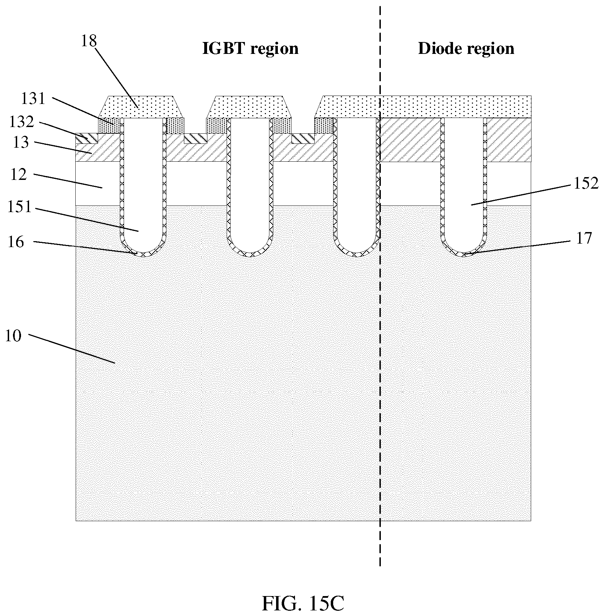

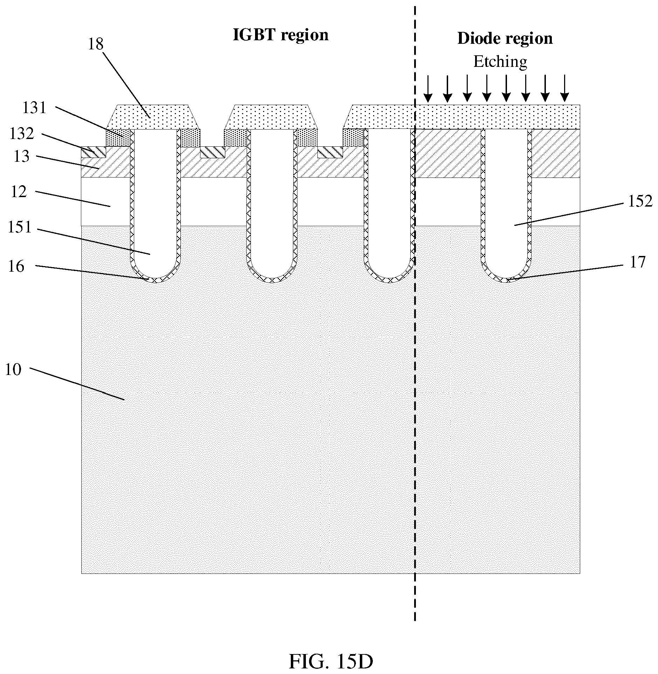

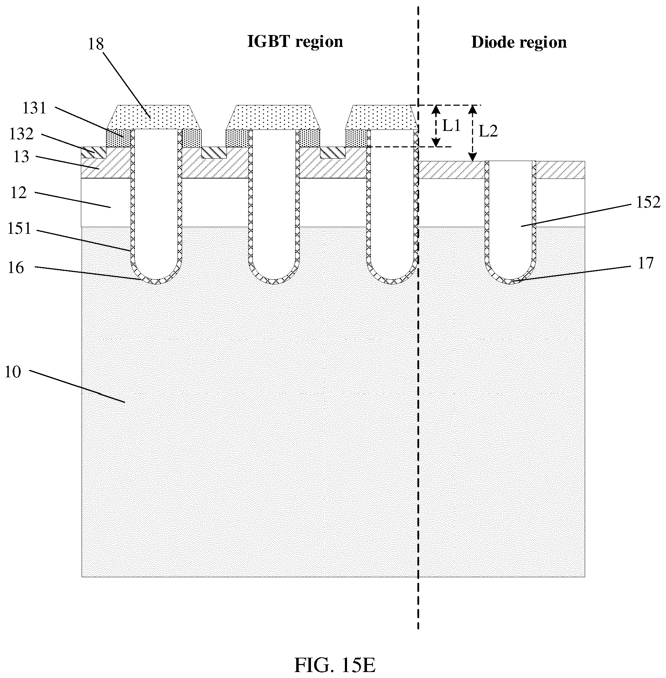

In another semiconductor device preparation method, after step S05, the insulation medium layer 18 and a part of the emitter region 131 that are located in the IGBT region may be etched, to form at least one second groove. The second groove penetrates the insulation medium layer 18 and the emitter region 131, and is configured to expose the second semiconductor layer 13, to obtain a semiconductor structure shown in FIG. 15A. Further, the second-conductivity-type impurity ion is injected into the second semiconductor layer 13 exposed in the second groove, to form the contact region 132, as shown in FIG. 15B and FIG. 15C. Further, as shown in FIG. 15D, S08 is sequentially performed, to obtain a semiconductor structure shown in FIG. 15E. An etching depth L1 of the second groove located in the IGBT region is less than an etching depth L2 of a layer structure located in the diode region. Because the to-be-etched insulation medium layers 18 have a same thickness, an etching depth of the emitter region 131 located in the IGBT region is less than an etching depth of the second semiconductor layer 13 located in the diode region, so that a thickness of the second semiconductor layer 13 in the diode region is reduced, and then carrier concentration in the diode region is reduced. In this way, front carrier injection efficiency when the diode is turned on is reduced, a reverse recovery charge amount when the diode is turned off is reduced, a reverse recovery loss Err is reduced, and switching efficiency of the RC-IGBT is finally improved.

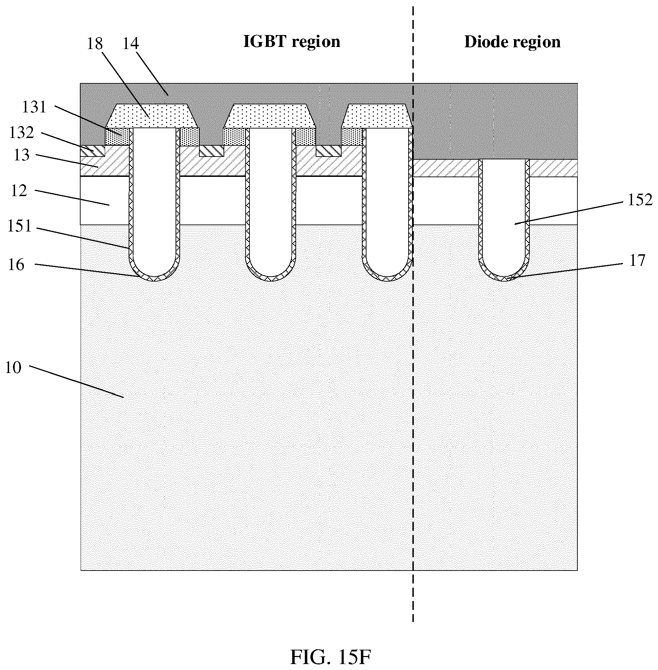

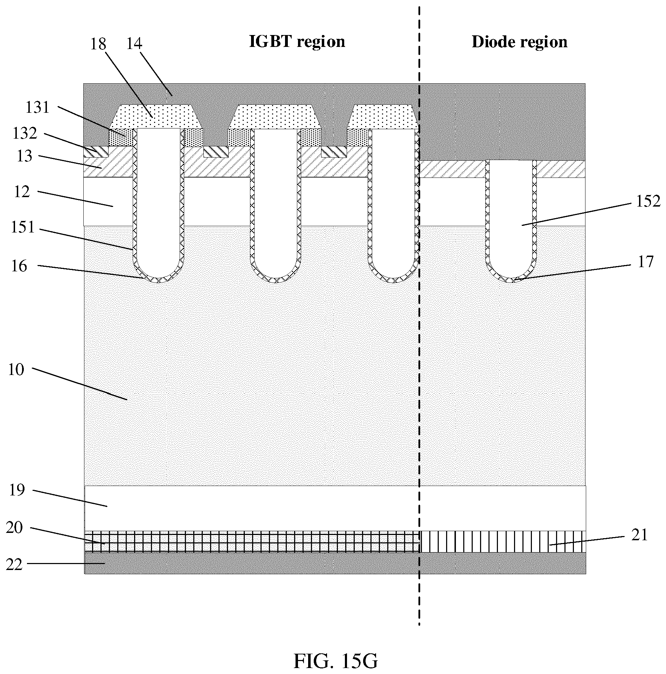

Further, a structure shown in FIG. 15F may be obtained by performing S09, and then a structure shown in FIG. 15G may be obtained by performing S10.

For specific implementation of each step, refer to related descriptions in the embodiment shown in FIG. 13. Details are not described herein again.

In another semiconductor device preparation method, to reduce preparation of a light cover and improve a process, the light cover and the process for preparing an IGBT may be used as much as possible.

For example, a contact region may also be formed in a diode region. When etching is performed in step S08, partial etching or complete etching is performed on the contact region of the diode region.

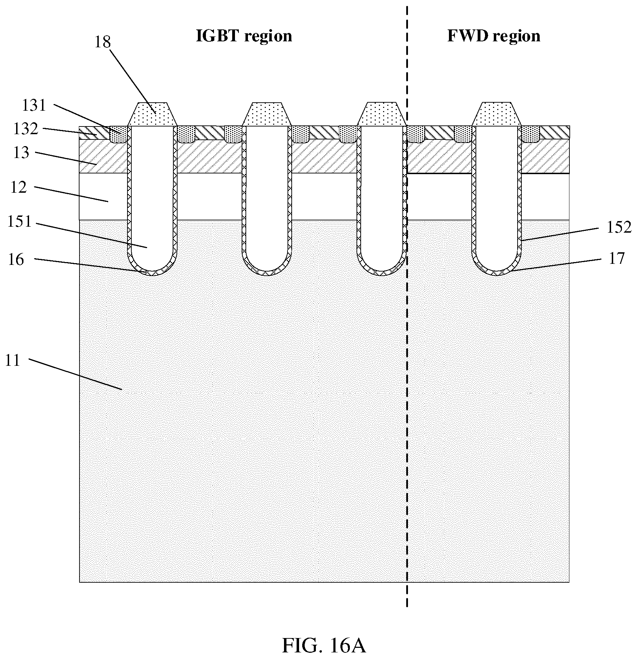

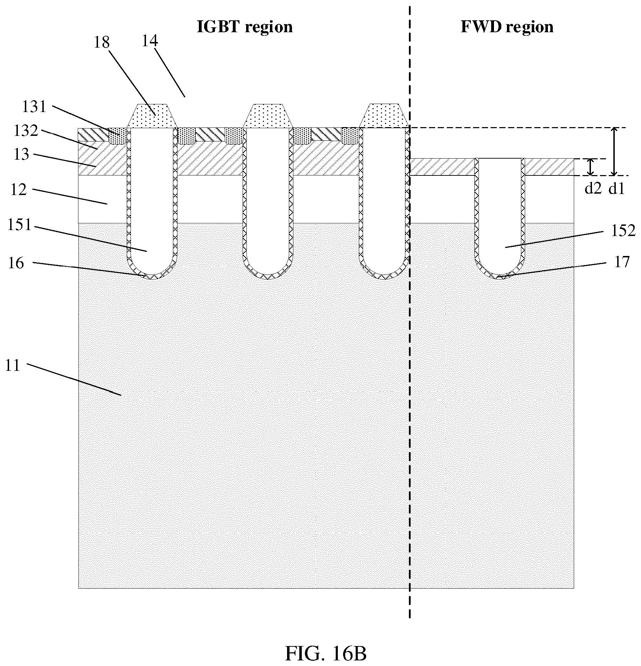

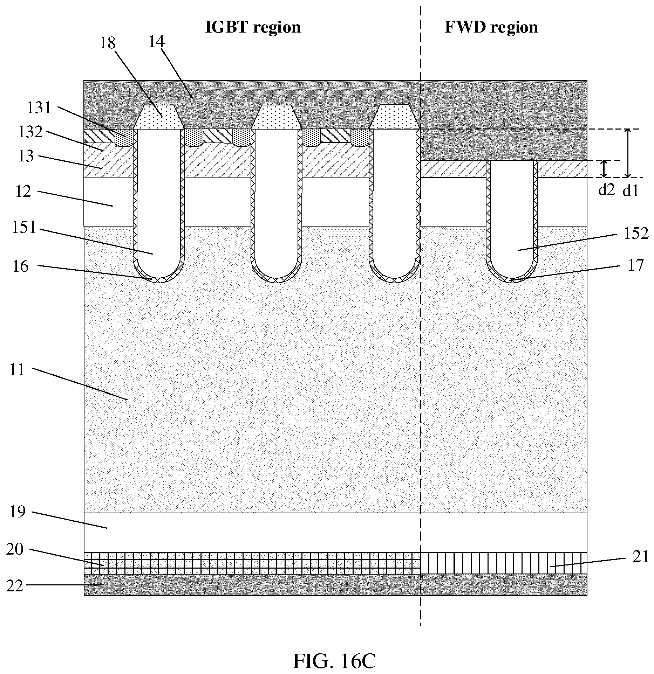

For another example, a structure shown in FIG. 16A is formed by using an IGBT forming process in the conventional technology. Further, the insulation medium layer 18, the emitter region 131, the contact region 132, the second semiconductor layer 13, the first electrode 152, and the second insulation layer 17 that are located in the diode region may be etched, to form a structure shown in FIG. 16B. In this way, the electrode layer 21, the collector layer 20, and the collector electrode 22 of the diode are sequentially formed on the second surface of the substrate 10, as shown in FIG. 16C.

For specific implementation of each step, refer to related descriptions in the embodiment shown in FIG. 13. Details are not described herein again.

It should be noted that, if first-conductivity-type is N-type and second-conductivity-type is P-type, the electrode layer is a negative electrode region of the diode; or if first-conductivity-type is P-type and second-conductivity-type is N-type, the electrode layer is a positive electrode region of the diode.

It should be further noted that the foregoing layer structures may be prepared by using a combination of a photolithography technology and a thin film preparation technology. This is not limited herein. This is not limited to the schematic diagrams of the preparation procedures shown in FIG. 14A to FIG. 14E, and another structure and another preparation method may be further included. This is not limited in this embodiment of this application.

As a switching device, the RC-IGBT is used as an energy conversion and transmission circuit, for example, used for frequency conversion, conversion, phase change, rectification, inversion, and switching of a voltage/current. In an application process, the RC-IGBT device may be encapsulated as a power module, for example, an IGBT discrete device, an IGBT module, and an intelligent power module (IPM). The IGBT discrete device may be the foregoing RC-IGBT chip. The IGBT module is obtained by packaging one or more RC-IGBT chips into a DBC substrate through insulation. The IPM is a "combined" device obtained by integrating the RC-IGBT device with peripheral circuits such as a drive circuit, an over-voltage and over-current protection circuit, and a temperature monitoring and over-temperature protection circuit.

The RC-IGBT may be used as a power conversion circuit implementing functions such as adjusting frequency conversion, conversion, phase change, rectification, inversion, and switching of a voltage/current, for example, an inverter circuit, a rectifier, or a converter circuit. The following separately describes the circuits and application scenarios of the circuits.
(1) The inverter circuit is a circuit that converts direct current electric energy into constant frequency and constant voltage alternating current power or frequency-modulated and voltage-regulated alternating current power, and usually includes an inverter bridge, logic control circuit, a filter circuit, and the like. The foregoing IGBT device is used as a switching device of the inverter bridge. An inverter circuit for which the semiconductor device provided in this application is used as a switching device may be used in a scenario in which a power supply is a direct current power supply and power needs to be supplied to an alternating current load. For example, when a battery in an electric vehicle supplies power to an alternating current motor, electric energy needs to be converted by using the inverter circuit. For another example, before a solar cell is provided to an alternating current grid, electric energy needs to be converted by using the inverter circuit.
(2) The rectifier is a circuit that converts alternating current electric energy into direct current electric energy, and usually includes a main circuit, a filter, and a converter. The main circuit may include a rectifier diode and the IGBT device provided in this application. The filter is connected between the main circuit and a load, and is configured to filter out an alternating current component in a pulsating direct current voltage. Whether to dispose the converter depends on a specific case. The converter is configured to: implement matching between an alternating current input voltage and a direct current output voltage, and electrically isolate an alternating current grid from the rectifier. The rectifier for which the semiconductor device provided in this application is used as a switching device may be used in a scenario in which alternating current power needs to be converted into direct current power. For example, when an electric vehicle charges a battery, alternating current power may be converted, by using a charging pile or a charger that includes the rectifier, into direct current power that has a rated voltage and that is required by the electric vehicle.
(3) The converter circuit may be a boost converter or a buck converter.

The boost converter is also referred to as a boost converter, and is a direct current-direct current converter that can step up a voltage. An output (a load) voltage of the boost converter is greater than an input (a power supply) voltage. The boost converter mainly includes switching power supplies of at least one diode, at least one transistor, and at least one energy storage element (inductor). The IGBT device provided in this application may be used as a transistor.

The buck converter is also referred to as a buck converter, and is a direct current-direct current converter that can step down a voltage. An output (a load) voltage of the buck converter is less than an input (a power supply) voltage, but an output current of the buck converter is greater than an input current. The buck converter mainly includes at least one diode, at least one transistor, and at least one energy storage element (a capacitor, an inductor, or both). Optionally, a filter that mainly includes a capacitor may be further added at an output end and an input end to reduce a voltage ripple. The IGBT device provided in this application may be used as a transistor.

For example, a voltage of a solar panel constantly changes due to a time or weather change. To ensure that all solar panels output rated power, the boost converter is added to a photovoltaic inverter, to regulate a voltage that is input to an inverter circuit, so that electric energy emitted by a solar cell is provided to an alternating current grid.

This is not limited to the foregoing circuits. The semiconductor device that is provided in this application and that is used as a switching device may be used in another circuit that requires a power semiconductor device, for example, a direct current boost circuit or a direct current buck circuit. This is not limited herein.

The RC-IGBT or the circuit or the device including the RC-IGBT may be further used in a vehicle such as an electric vehicle or a subway vehicle, or may be used in a home appliance such as a variable frequency air conditioner or a variable frequency refrigerator, or may be used in a photovoltaic device or the like.

The technical terms used in embodiments of the present invention are merely used to describe specific embodiments, but are not intended to limit the present invention. In this specification, singular forms "one", "this", and "the" are intended to simultaneously include plural forms unless otherwise clearly specified in the context. Further, the term "including" and/or "containing" used in this specification refers to presence of features, entireties, steps, operations, elements and/or components, but does not exclude presence or addition of one or more other features, entireties, steps, operations, elements and/or components.

## Claims

1. A semiconductor device, comprising:
a first-conductivity-type first semiconductor layer (11), wherein the first semiconductor layer comprises a first surface and a second surface that are opposite to each other, an insulated gate bipolar transistor, IGBT, region used to form an IGBT, and a diode region used to form a diode;
a second-conductivity-type second semiconductor layer (13) disposed on the first surface of the first semiconductor layer (11), wherein a thickness of the second semiconductor layer (13) located in the IGBT region is greater than a thickness of the second semiconductor layer (13) located in the diode region, and wherein
the second semiconductor layer (13) comprises a first surface away from the first semiconductor layer (11) and a second surface facing the first semiconductor layer (11),
wherein a first section of the second surface of the second semiconductor layer (13) located in the IGBT region is aligned along a first direction with a second section of the second surface of the second semiconductor layer (13) located in the diode region, the first direction is substantially perpendicular to a thickness direction;
a first-conductivity-type emitter region (131) disposed on the first surface of the second semiconductor layer (13) located in the IGBT region; and
a collector layer (20) and an electrode layer (21) that are disposed on the second surface of the first semiconductor layer (11), wherein the collector layer (20) and the electrode layer (21) are respectively disposed relative to the IGBT region and the diode region.

2. The semiconductor device according to claim 1, wherein the thickness of the second semiconductor layer (13) located in the IGBT region is 0.5 to 3 micrometers, and the thickness of the second semiconductor layer (13) located in the diode region is 0.5 to 2.5 micrometers.

3. The semiconductor device according to claim 1, wherein a ratio of the thickness of the second semiconductor layer (13) located in the diode region to the thickness of the second semiconductor layer (13) located in the IGBT region is 0.2 to 0.8.

4. The semiconductor device according to any one of claims 1 to 3, wherein the second semiconductor layer (13) located in the IGBT region comprises a second-conductivity-type contact region (132), the semiconductor device comprises a plurality of emitter regions (131) disposed at intervals, the contact region (132) is disposed between two adjacent emitter regions (131), and second-conductivity-type impurity concentration in the contact region (132) is greater than second-conductivity-type impurity concentration in the second semiconductor layer (13).

5. The semiconductor device according to claim 4, wherein the second semiconductor layer (13) located in the diode region does not comprise the second-conductivity-type contact region (132).

6. The semiconductor device according to any one of claims 4 or 5, wherein a difference between the thickness of the second semiconductor layer (13) located in the IGBT region and the thickness of the second semiconductor layer (13) located in the diode region is not less than a thickness of the contact region (132).

7. The semiconductor device according to any one of claims 1 to 6, further comprising:
at least one gate electrode (151) that penetrates the second semiconductor layer (13) and that is in contact with the first semiconductor layer (11) located in the IGBT region; and
a first insulation layer (16) disposed between each gate electrode (151) and the first semiconductor layer (11).

8. The semiconductor device according to claim 7, wherein one end of the gate electrode (151) is substantially flush with
a surface, of the emitter region, away from the first semiconductor layer (11).

9. The semiconductor device according to any one of claims 1 to 8, further comprising:
at least one first electrode (152) that penetrates the second semiconductor layer (13) and that is in contact with the first semiconductor layer (11) located in the diode region; and
a second insulation layer (17) disposed between each first electrode and the first semiconductor layer (11).

10. The semiconductor device according to claim 9, wherein one end of the first electrode (152) is substantially flush with the second semiconductor layer (13) located in the diode region.

11. The semiconductor device according to any one of claims 1 to 10, wherein a first-conductivity-type carrier storage, CS, layer (12) is further comprised between the first semiconductor layer (11) and the second semiconductor layer (13).

12. The semiconductor device according to any one of claims 1 to 11, wherein the first semiconductor layer (11) comprises a first-conductivity-type pillar and a second-conductivity-type pillar that are arranged alternately along the first direction, and both the first-conductivity-type pillar and the second-conductivity-type pillar extend along the thickness direction.

13. A power conversion circuit, comprising at least the semiconductor device according to any one of claims 1 to 12.

14. A reverse conduction insulated gate bipolar transistor, RC-IGBT, chip, comprising at least the semiconductor device according to any one of claims 1 to 12.

15. An electronic device, comprising at least the semiconductor device according to any one of claims 1 to 12 or comprising the RC-IGBT chip according to claim 14.

## Patentansprüche

1. Halbleitervorrichtung, die umfasst:
eine erste Halbleiterschicht (11) eines ersten Leitfähigkeitstyps, wobei die erste Halbleiterschicht eine erste Oberfläche und eine zweite Oberfläche, die einander gegenüberliegen, einen Bereich eines Bipolartransistors mit isoliertem Gate, IGBT, der verwendet wird, um einen IGBT auszubilden, und einen Diodenbereich, der verwendet wird, um eine Diode auszubilden, umfasst;
eine zweite Halbleiterschicht (13) eines zweiten Leitfähigkeitstyps, die auf der ersten Oberfläche der ersten Halbleiterschicht (11) angeordnet ist, wobei eine Dicke der zweiten Halbleiterschicht (13), die sich in dem IGBT-Bereich befindet, größer als eine Dicke der zweiten Halbleiterschicht (13) ist, die sich in dem Diodenbereich befindet, und wobei die zweite Halbleiterschicht (13) eine von der ersten Halbleiterschicht (11) abgewandte erste Oberfläche und eine der ersten Halbleiterschicht (11) zugewandte zweite Oberfläche umfasst,
wobei ein erster Abschnitt der zweiten Oberfläche der zweiten Halbleiterschicht (13), der sich in dem IGBT-Bereich befindet, entlang einer ersten Richtung mit einem zweiten Abschnitt der zweiten Oberfläche der zweiten Halbleiterschicht (13), der sich in dem Diodenbereich befindet, ausgerichtet ist, wobei die erste Richtung im Wesentlichen senkrecht zu einer Dickenrichtung verläuft;
einen Emitterbereich (131) eines ersten Leitfähigkeitstyps, der auf der ersten Oberfläche der zweiten Halbleiterschicht (13), die sich im IGBT-Bereich befindet, angeordnet ist; und
eine Kollektorschicht (20) und eine Elektrodenschicht (21), die auf der zweiten Oberfläche der ersten Halbleiterschicht (11) angeordnet sind, wobei die Kollektorschicht (20) und die Elektrodenschicht (21) jeweils relativ zu dem IGBT-Bereich und dem Diodenbereich angeordnet sind.

2. Halbleitervorrichtung nach Anspruch 1, wobei die Dicke der zweiten Halbleiterschicht (13), die sich in dem IGBT-Bereich befindet, 0,5 bis 3 Mikrometer beträgt und die Dicke der zweiten Halbleiterschicht (13), die sich in dem Diodenbereich befindet, 0,5 bis 2,5 Mikrometer beträgt.

3. Halbleitervorrichtung nach Anspruch 1, wobei ein Verhältnis der Dicke der zweiten Halbleiterschicht (13), die sich in dem Diodenbereich befindet, zu der Dicke der zweiten Halbleiterschicht (13), die sich in dem IGBT-Bereich befindet, 0,2 bis 0,8 beträgt.

4. Halbleitervorrichtung nach einem der Ansprüche 1 bis 3, wobei die zweite Halbleiterschicht (13), die sich in dem IGBT-Bereich befindet, einen Kontaktbereich (132) eines zweiten Leitfähigkeitstyps umfasst, die Halbleitervorrichtung eine Vielzahl von Emitterbereichen (131), die in Abständen angeordnet sind, umfasst, der Kontaktbereich (132) zwischen zwei angrenzenden Emitterbereichen (131) angeordnet ist und eine Störstellenkonzentration eines zweiten Leitfähigkeitstyps in dem Kontaktbereich (132) größer als eine Störstellenkonzentration eines zweiten Leitfähigkeitstyps in der zweiten Halbleiterschicht (13) ist.

5. Halbleitervorrichtung nach Anspruch 4, wobei die zweite Halbleiterschicht (13), die sich in dem Diodenbereich befindet, den Kontaktbereich (132) eines zweiten Leitfähigkeitstyps nicht umfasst.

6. Halbleitervorrichtung nach einem der Ansprüche 4 oder 5, wobei eine Differenz zwischen der Dicke der zweiten Halbleiterschicht (13), die sich in dem IGBT-Bereich befindet, und der Dicke der zweiten Halbleiterschicht (13), die sich in dem Diodenbereich befindet, nicht geringer als eine Dicke des Kontaktbereichs (132) ist.

7. Halbleitervorrichtung nach einem der Ansprüche 1 bis 6, die ferner umfasst:
mindestens eine Gate-Elektrode (151), die die zweite Halbleiterschicht (13) durchdringt und
die mit der ersten Halbleiterschicht (11), die sich in dem IGBT-Bereich befindet, in Kontakt steht; und
eine erste Isolierschicht (16), die zwischen jeder Gate-Elektrode (151) und der ersten Halbleiterschicht (11) angeordnet ist.

8. Halbleitervorrichtung nach Anspruch 7, wobei ein Ende der Gate-Elektrode (151) im Wesentlichen bündig ist mit
einer Oberfläche des Emitterbereichs, die von der ersten Halbleiterschicht (11) abgewandt ist.

9. Halbleitervorrichtung nach einem der Ansprüche 1 bis 8, die ferner umfasst:
mindestens eine erste Elektrode (152), die die zweite Halbleiterschicht (13) durchdringt und die mit der ersten Halbleiterschicht (11), die sich in dem Diodenbereich befindet, in Kontakt steht; und
eine zweite Isolierschicht (17), die zwischen jeder ersten Elektrode und der ersten Halbleiterschicht (11) angeordnet ist.

10. Halbleitervorrichtung nach Anspruch 9, wobei ein Ende der ersten Elektrode (152) im Wesentlichen bündig ist mit der zweiten Halbleiterschicht (13), die sich in dem Diodenbereich befindet.

11. Halbleitervorrichtung nach einem der Ansprüche 1 bis 10, wobei ferner eine Ladungsträgerspeicher(CS)-Schicht (12) eines ersten Leitfähigkeitstyps zwischen der ersten Halbleiterschicht (11) und der zweiten Halbleiterschicht (13) umfasst ist.

12. Halbleitervorrichtung nach einem der Ansprüche 1 bis 11, wobei die erste Halbleiterschicht (11) eine Säule eines ersten Leitfähigkeitstyps und eine Säule eines zweiten Leitfähigkeitstyps umfasst, die abwechselnd entlang der ersten Richtung eingerichtet sind, und sich sowohl die Säule eines ersten Leitfähigkeitstyps als auch die Säule des zweiten Leitfähigkeitstyps entlang der Dickenrichtung erstrecken.

13. Leistungsumwandlungsschaltung, die mindestens die Halbleitervorrichtung nach einem der Ansprüche 1 bis 12 umfasst.

14. Chip mit einem rückwärtsleitenden Bipolartransistor mit isoliertem Gate, RC-IGBT, der mindestens die Halbleitervorrichtung nach einem der Ansprüche 1 bis 12 umfasst.

15. Elektronische Vorrichtung, die mindestens die Halbleitervorrichtung nach einem der Ansprüche 1 bis 12 umfasst oder den RC-IGBT-Chip nach Anspruch 14 umfasst.

## Revendications

1. Dispositif semi-conducteur, comprenant :
une première couche semi-conductrice (11) de premier type de conductivité, dans lequel la première couche semi-conductrice comprend une première surface et une seconde surface opposées l'une à l'autre, une région formant transistor bipolaire à grille isolée, IGBT, utilisée pour former un IGBT, et une région formant diode utilisée pour former une diode ;
une seconde couche semi-conductrice (13) de second type de conductivité disposée sur la première surface de la première couche semi-conductrice (11), dans lequel une épaisseur de la seconde couche semi-conductrice (13) située dans la région formant IGBT est supérieure à une épaisseur de la seconde couche semi-conductrice (13) située dans la région formant diode, et dans lequel la seconde couche semi-conductrice (13) comprend une première surface éloignée de la première couche semi-conductrice (11) et une seconde surface faisant face à la première couche semi-conductrice (11),
dans lequel une première section de la seconde surface de la seconde couche semi-conductrice (13) située dans la région formant IGBT est alignée, le long d'une première direction, sur une seconde section de la seconde surface de la seconde couche semi-conductrice (13) située dans la région formant diode, la première direction est sensiblement perpendiculaire à une direction d'épaisseur ;
une région formant émetteur (131) de premier type de conductivité disposée sur la première surface de la seconde couche semi-conductrice (13) située dans la région formant IGBT ;
et
une couche de collecteur (20) et une couche d'électrode (21) disposées sur la seconde surface de la première couche semi-conductrice (11), dans lequel la couche de collecteur (20) et la couche d'électrode (21) sont respectivement disposées par rapport à la région formant IGBT et à la région formant diode.

2. Dispositif semi-conducteur selon la revendication 1, dans lequel l'épaisseur de la seconde couche semi-conductrice (13) située dans la région formant IGBT est de 0,5 à 3 micromètres, et l'épaisseur de la seconde couche semi-conductrice (13) située dans la région formant diode est de 0,5 à 2,5 micromètres.

3. Dispositif semi-conducteur selon la revendication 1, dans lequel un rapport entre l'épaisseur de la seconde couche semi-conductrice (13) située dans la région formant diode et l'épaisseur de la seconde couche semi-conductrice (13) située dans la région formant IGBT est de 0,2 à 0,8.

4. Dispositif semi-conducteur selon l'une quelconque des revendications 1 à 3, dans lequel la seconde couche semi-conductrice (13) située dans la région formant IGBT comprend une région formant contact (132) de second type de conductivité, le dispositif semi-conducteur comprend une pluralité de régions formant émetteurs (131) disposées à certains intervalles, la région formant contact (132) est disposée entre deux régions formant émetteurs (131) adjacentes, et une concentration d'impuretés de second type de conductivité dans la région formant contact (132) est supérieure à une concentration d'impuretés de second type de conductivité dans la seconde couche semi-conductrice (13).

5. Dispositif semi-conducteur selon la revendication 4, dans lequel la seconde couche semi-conductrice (13) située dans la région formant diode ne comprend pas la région formant contact (132) de second type de conductivité.

6. Dispositif semi-conducteur selon l'une quelconque des revendications 4 ou 5, dans lequel une différence entre l'épaisseur de la seconde couche semi-conductrice (13) située dans la région formant IGBT et l'épaisseur de la seconde couche semi-conductrice (13) située dans la région formant diode n'est pas inférieure à une épaisseur de la région formant contact (132).

7. Dispositif semi-conducteur selon l'une quelconque des revendications 1 à 6, comprenant en outre :
au moins une électrode de grille (151) qui pénètre dans la seconde couche semi-conductrice (13) et qui est en contact avec la première couche semi-conductrice (11) située dans la région formant IGBT ;
et
une première couche isolante (16) disposée entre chaque électrode de grille (151) et la première couche semi-conductrice (11).

8. Dispositif semi-conducteur selon la revendication 7, dans lequel une extrémité de l'électrode de grille (151) est sensiblement au même niveau qu'une surface, de la région formant émetteur, éloignée de la première couche semi-conductrice (11).

9. Dispositif semi-conducteur selon l'une quelconque des revendications 1 à 8, comprenant en outre :
au moins une première électrode (152) qui pénètre dans la seconde couche semi-conductrice (13) et qui est en contact avec la première couche semi-conductrice (11) située dans la région formant diode ; et
une seconde couche isolante (17) disposée entre chaque première électrode et la première couche semi-conductrice (11).

10. Dispositif semi-conducteur selon la revendication 9, dans lequel une extrémité de la première électrode (152) est sensiblement au même niveau que la seconde couche semi-conductrice (13) située dans la région formant diode.

11. Dispositif semi-conducteur selon l'une quelconque des revendications 1 à 10, dans lequel une couche d'accumulation de porteurs, CS, (12) de premier type de conductivité est en outre comprise entre la première couche semi-conductrice (11) et la seconde couche semi-conductrice (13).

12. Dispositif semi-conducteur selon l'une quelconque des revendications 1 à 11, dans lequel la première couche semi-conductrice (11) comprend un pilier de premier type de conductivité et un pilier de second type de conductivité qui sont agencés alternativement le long de la première direction,
et le pilier de premier type de conductivité et le pilier de second type de conductivité s'étendent tous deux le long de la direction d'épaisseur.

13. Circuit convertisseur de puissance, comprenant au moins le dispositif semi-conducteur selon l'une quelconque des revendications 1 à 12.

14. Puce de transistor bipolaire à grille isolée à conduction inverse, RC-IGBT, comprenant au moins le dispositif semi-conducteur selon l'une quelconque des revendications 1 à 12.

15. Dispositif électronique, comprenant au moins le dispositif semi-conducteur selon l'une quelconque des revendications 1 à 12 ou comprenant la puce RC-IGBT selon la revendication 14.
